# EUROPÄISCHE PATENTANMELDUNG

(11) **EP 3 335 925 A1**
(43) Veröffentlichungstag der Anmeldung: **20.06.2018**
(21) Anmeldenummer: 16204548.8
(22) Anmeldetag: 15.12.2016
(51) Int. Cl.: B60L 11/18, H02M 1/42, H02J 7/02, G06Q 50/06, H02J 3/12, H02J 13/00, B60L 3/00, H02J 3/18, G01R 19/25, H02J 3/16, H02M 1/00

(54) **VORRICHTUNG ZUR KOORDINIERTEN BLINDLEISTUNGSERZEUGUNG UND -REGELUNG UND VIRTUELLES BLINDLEISTUNGSKRAFTWERK AUF BASIS DERSELBEN**

(71) Anmelder: Technische Hochschule Mittelhessen, 35390 Giessen (DE)
(72) Erfinder: Dib, Ramzi, 61169 Friedberg (DE); Wörner, Benjamin, 61137 Schöneck (DE)
(74) Vertreter: Stumpf, Peter

(57) **Zusammenfassung**

Die Erfindung betrifft eine Vorrichtung zur zentral koordinierten Blindleistungserzeugung und -regelung in elektrischen Niederspannungsnetzen. Es handelt sich dabei um eine permanent mit dem Netz verbundene Kombination aus einer Stromversorgungseinrichtung für Elektrofahrzeuge und einem fernsteuerbaren Blindleistungsmodul. Zum einen ersetzt die Erfindung eine übliche Versorgungseinrichtung für Elektrofahrzeuge, an der ein Elektrofahrzeug über das entsprechende Ladegerät aufgeladen werden kann, und zum anderen wird durch die Erfindung die leistungsstarke Infrastruktur der Elektromobilität zur Blindleistungserzeugung und -regelung für das gesamte elektrische Netz mittels fernsteuerbarem Blindleistungsmodul genutzt. Ein bevorstehender Mangel an koordinierter und hochverfügbarer Blindleistungserzeugung und -regelung, bedingt durch den Wegfall der konventionellen Kraftwerke im Zuge der Energiewende, der zu Spannungs- und Effizienzproblemen im Netz bis hin zu Blackouts führen kann, wird durch Bildung eines virtuellen Blindleistungskraftwerks, das über mindestens eine übergeordnete Instanz und Kommunikationsverbindungen verfügt, behoben.

## Beschreibung

### Technisches Gebiet der Erfindung

Die Erfindung betrifft das Gebiet der elektrischen Stromnetze, insbesondere der intelligenten Stromnetze (Smart Grids), sowie das Gebiet der Elektromobilität. Die Erfindung erschließt einen Synergieeffekt zwischen diesen beiden Gebieten.

### Stand der Technik

Für einen zuverlässigen und effizienten Netzbetrieb, zu dem die Betreiber elektrischer Energienetze gesetzlich verpflichtet sind, wird in elektrischen Energienetzen eine zentral koordinierte und hochverfügbare Blindleistungserzeugung und -regelung benötigt. Durch die Bereitstellung von Blindleistung, welche eine Regelung der Netzspannung ermöglicht, wird gewährleistet, dass die Netzspannung innerhalb von definierten Spannungsbändern gehalten wird. Unter Umständen kann ein Netz einen Spannungszusammenbruch (Blackout) erfahren, wenn die zur Regelung der Netzspannung erforderliche Blindleistung nicht zur Verfügung steht.

Die Anforderungen an die Betreiber elektrischer Energienetze sind beispielhaft im Energiewirtschaftsgesetz der Bundesrepublik Deutschland (EnWG) dargelegt. Die Betreiber sind gesetzlich verpflichtet, einen zuverlässigen und effizienten Betrieb dieser Netze sicherzustellen. So fordert § 1 des EnWG "eine möglichst sichere, preisgünstige, verbraucherfreundliche, effiziente und umweltverträgliche leitungsgebundene Versorgung der Allgemeinheit mit Elektrizität und Gas, die zunehmend auf erneuerbaren Energien beruht", wobei die "Regulierung der Elektrizitäts- und Gasversorgungsnetze ... den Zielen ... der Sicherung eines langfristig angelegten leistungsfähigen und zuverlässigen Betriebs von Energieversorgungsnetzen" dient.

Die Erfordernisse Sicherheit, Zuverlässigkeit, Langfristigkeit, Leistungsfähigkeit und Effizienz sind im Rahmen dieser Anmeldung wie folgt zu verstehen:
Sicherheit bezeichnet die Haltung wichtiger Netzparameter, insbesondere der Spannung und der Frequenz, innerhalb von vorgeschriebenen Bändern. Bezogen auf einen vorgeschriebenen Sollwert ist die Spannung in einer Bandbreite von ± 10 % zu halten. An einer 230-V-Steckdose innerhalb eines Niederspannungsnetzes, das eine verkettete Spannung von 400 V aufweist, ist die Spannung somit in einem Band zwischen 207 V und 253 V zu halten. Zu hohe Spannungswerte verkürzen die Lebensdauer angeschlossener Geräte, z. B. durch Überspannungsschäden. Zu geringe Spannungswerte mindern die Leistungsabgabe solcher Geräte oder beeinträchtigen deren Funktionalität.

Zuverlässigkeit bezeichnet eine jederzeitige Verfügbarkeit elektrischer Energie für alle Verbraucher, sowohl industrielle als auch private. Die Verbraucher sind ihrem Bedarf entsprechend unterbrechungsfrei mit elektrischer Energie zu versorgen. In den vergangenen Jahrzehnten wurden ungeplante Unterbrechungen für den privaten Verbraucher auf weniger als 15 min im Jahr reduziert. Diese hohe Zuverlässigkeit muss beim Übergang zu erneuerbaren Energien beibehalten und weiter verbessert werden.

Langfristigkeit bedeutet, Maßnahmen zum Ausbau der Netzinfrastruktur und der lokalen Elektroinstallationen so durchzuführen, dass über Jahrzehnte keine zusätzlichen Maßnahmen erforderlich sind. Für die Infrastruktur der Elektromobilität, welche das Laden und Entladen der Batterien von Elektrofahrzeugen innerhalb eines Stromnetzes ermöglicht, ist bereits vorgeschrieben, dass Stromversorgungseinrichtungen für Elektrofahrzeuge (Electric Vehicle Supply Equipment, EVSE) über ausschließlich (explizit) für die Elektromobilität vorgesehene dreiphasige Drehstromverbindungen, die für 32 A je Phase ausgelegt sind, anzuschließen sind. Diese 3x32-A-Stromverbindungen werden auch für Elektrofahrzeuge mit zukünftig höherer Batteriekapazität, d. h. höherer speicherbarer Energie, und damit verbundenen höherer Lade- bzw. Entladeleistung ausreichend sein.

Leistungsfähigkeit bedeutet, dass der Gesamtheit der Verbraucher auch in Zeiten hohen Verbrauchs (Spitzenzeiten) die benötigte elektrische Energie bedarfsgerecht bereitgestellt wird. Ebenso wird darunter das Übertragen und Verteilen von Energie zwischen Erzeugern und Verbrauchern ohne Engpässe verstanden.

Effizienz bedeutet, dass die bestehenden Energienetze optimal ausgenutzt werden, sodass Maßnahmen zum Netzausbau minimiert werden. Die Effizienz ist insbesondere durch ein leistungsfähiges Netzmanagement sicherzustellen, welches die kritischen Netzparameter, insbesondere Spannung und Frequenz, innerhalb der vorgeschriebenen Bänder hält und somit die Stabilität des Netzbetriebs gewährleistet.

Gegenwärtig wird die für einen stabilen Netzbetrieb erforderliche zentral koordinierte und hochverfügbare Blindleistungserzeugung und -regelung noch durch konventionelle Großkraftwerke sichergestellt. Allerdings wird dieses auf konventionellen Großkraftwerken basierende Blindleistungspotential im Zuge der Energiewende, d. h. des Übergangs von fossilen und atomaren Großkraftwerken zu dezentralen Anlagen zur Erzeugung erneuerbarer Energien, sukzessive zurückgebaut und steht zukünftig nicht mehr zur Verfügung. Die nachrückenden dezentralen Erzeugungsanlagen für erneuerbare Energien sind nicht in der Lage, die für die Regelung der Netzspannung erforderliche Menge an Blindleistung bereitstellen. Zudem sind diese Anlagen in der Regel nicht für eine zentral koordinierte und hochverfügbare Erzeugung und Regelung von Blindleistung ausgelegt. Die Blindleistungsbereitstellung einer solchen dezentralen Erzeugungsanlage dient lediglich der Reduzierung eines Spannungsanstiegs, der durch die Wirkleistungseinspeisung dieser dezentralen Erzeugungsanlage selbst verursacht wird. Dementsprechend sind die hierbei verwendeten Regelverfahren nur lokal auf die Minderung des eigenen Einflusses der dezentralen Erzeugungsanlage auf die Netzspannung ausgerichtet. Um einen durch die Integration einer großen Anzahl von dezentralen Erzeugungsanlagen für erneuerbare Energien in das Netz bedingten Spannungsanstieg zu reduzieren, misst jede dezentrale Erzeugungsanlage den Spannungsanstieg an ihrem Netzverknüpfungspunkt und senkt durch eine Einspeisung kapazitiver Blindleistung in das Netz (was einem Bezug induktiver Blindleistung aus dem Netz entspricht) die Netzspannung an ihrem Netzverknüpfungspunkt auf einen vorgeschriebenen Sollwert. Die einzelnen dezentralen Erzeugungsanlagen speisen somit unabhängig voneinander Blindleistung in das Netz ein. Eine zentral koordinierte Erzeugung und Regelung von Blindleistung findet nicht statt. Ein Netzverknüpfungspunkt bildet gemäß den Normen VDE-AR-N 4105:2011-08 und DIN EN 50160:2010 die Grenze zwischen zwei Verantwortungsbereichen, hier zwischen den Verantwortungsbereichen des Betreibers der dezentralen Erzeugungsanlage und des Netzbetreibers. Er bildet zudem eine Übergabestelle für Energie und/oder Information.

Durch den nationalen und internationalen Markthochlauf der Elektromobilität motiviert, wird an einer lokalen Blindleistungsregelung durch Elektrofahrzeuge geforscht, da das Laden der Batterien von Elektrofahrzeugen in großer Anzahl eine große Last für das Netz darstellt. Große Lasten im elektrischen Netz wirken in unerwünschter Weise spannungssenkend. Ähnlich wie bei der Integration von dezentralen Erzeugungsanlagen in das Netz kann auch hier durch die Einspeisung von Blindleistung der unerwünschte Einfluss auf die Netzspannung, hier eine unerwünschte Spannungssenkung, reduziert werden, indem durch Einspeisung induktiver Blindleistung in das Netz (entsprechend dem Bezug kapazitiver Blindleistung aus dem Netz) die Netzspannung am Netzverknüpfungspunkt des Elektrofahrzeugs, also lokal, auf einen vorgeschriebenen Sollwert angehoben wird. Es sind blindleistungsfähige Ladegeräte für Elektrofahrzeuge bekannt, die eine solche lokale Blindleistungsregelung, analog zu dem oben beschriebenen Verfahren der dezentralen, unkoordinierten Blindleistungsregelung durch dezentrale Erzeugungsanlagen für erneuerbare Energien gewährleisten. Blindleistungsfähige Ladegeräte können als interne Ladegeräte in ein Elektrofahrzeug integriert sein und mit diesem mitbewegt werden. Für eine koordinierte Blindleistungserzeugung und -regelung sind sie aufgrund der folgenden Merkmale nicht geeignet:
Die internen blindleistungsfähigen Ladegeräte können dem Netz nur dann Blindleistung bereitstellen, wenn sie bei geparktem Elektrofahrzeug über eine EVSE mit dem Netz verbunden sind. Dabei ist lediglich eine lokale Regelung möglich, bei welcher die Netzspannung am Netzverknüpfungspunkt der jeweiligen EVSE optimiert wird. Eine koordinierte Blindleistungseinspeisung durch die Ladegeräte mehrerer Elektrofahrzeuge ist nicht möglich, da die Ladegeräte über keine Kommunikationsmöglichkeiten verfügen. Die Mobilität des Ladegeräts durch den Einbau in das Elektrofahrzeug schließt aus, dass es ein zuverlässiges Blindleistungspotential bereitstellen kann, denn ein Netzbetreiber erhält keine Vorabinformation darüber, an welchem Ort und in welchem Zeitraum das Ladegerät eines Elektrofahrzeugs Blindleistung in das elektrische Netz einspeisen wird.

Die Bereitstellung externer blindleistungsfähiger Ladegeräte (d. h. stationärer, nicht in Elektrofahrzeuge eingebauter, Ladegeräte) würde zwar das Problem des ungewissen Standortes lösen, allerdings ist diese Lösung nicht wirtschaftlich. Externe Ladegeräte sind um ein Vielfaches teurer als interne, d. h. mit einem Fahrzeug mitbewegte, Ladegeräte. Da Elektrofahrzeuge derzeit standardmäßig mit einem internen Ladegerät ausgestattet sind, ist die zusätzliche Bereitstellung externer Ladegeräte mit oder ohne Blindleistungsfähigkeit derzeit nicht erforderlich und unwirtschaftlich. Entsprechende Investitionen sind daher nicht vorgesehen.

Weder mengenmäßig noch durch die nachteilige dezentrale und unkoordinierte Blindleistungsregelung in den Erzeugungsanlagen der Erneuerbaren Energien oder Ladegeräten der Elektromobilität kann der bevorstehende Mangel an zentral koordinierter Blindleistungserzeugung und -regelung behoben werden. Dieser Mangel wird zu Spannungs- und Effizienzproblemen führen, die den Netzbetrieb gefährden und die Gefahr von Blackouts fördern. Diese Probleme werden durch die derzeitige unkoordinierte Blindleistungseinspeisung an einer Vielzahl von Netzverknüpfungspunkten sogar verschärft. Dies trifft für PV-Anlagen mit Peakleistungen unter 30 kW und für EVSE mit 22 kW Anschlussleistung, deren Netzverknüpfungspunkte sich überwiegend im Niederspannungsnetz befinden, zu.

### Aufgabe der Erfindung

Aufgabe der Erfindung ist es daher, im Niederspannungsnetz vorhandene, bisher unerkannte Potenziale zur koordinierten und hochverfügbaren Bereitstellung von Blindleistung aufzuzeigen und zu erschließen.

Ferner ist es Aufgabe der Erfindung, Vorrichtungen anzugeben, die es erlauben, einem elektrischen Niederspannungsnetz und seinen vorgelagerten Netzebenen eine ausreichende Menge von koordiniert regelbarer Blindleistung hochverfügbar bereitzustellen.

### Erfindungsgemäße Lösung

Die Aufgabe der Erfindung wird gelöst durch eine Vorrichtung gemäß einem der Ansprüche 1 bis 10, die eine neuartige Kombination einer permanent mit einem elektrischen Niederspannungsnetz verbundenen Stromversorgungseinrichtung für Elektrofahrzeuge (Electric Vehicle Supply Equipment - EVSE) mit einem Blindleistungsmodul, das zum Zwecke einer koordinierten Blindleistungserzeugung und -regelung fernsteuerbar ausgeführt ist, aufweist. Die Kombination dieser beiden Komponenten in einer Vorrichtung ist nicht aus dem Stand der Technik bekannt.

Die Aufgabe der Erfindung wird ferner dadurch gelöst, dass eine oder mehrere Vorrichtungen gemäß einem der Ansprüche 1 bis 10 zu einem Cluster kombiniert werden. Jede Vorrichtung ist über ihre Stromversorgungseinrichtung für Elektrofahrzeuge und ihr fernsteuerbares Blindleistungsmodul mit mindestens einer koordinierenden übergeordneten Instanz verbindbar, durch welche die Blindleistungserzeugung und -regelung jeder Vorrichtung im Gesamtkontext eines elektrischen Niederspannungsnetzes und ggf. seiner vorgelagerten Netzebenen steuerbar ist, sodass ein virtuelles Blindleistungskraftwerk gemäß den Ansprüchen 12 bis 14 gebildet wird.

Letztlich wird die Aufgabe der Erfindung gelöst durch die Angabe eines Verfahrens zum Betrieb dieses virtuellen Blindleistungskraftwerks gemäß den Ansprüchen 15 und 16.

### Detaillierte Beschreibung der Lösung

Im Zuge der Energiewende hin zu erneuerbaren Energien entfällt in Deutschland in den kommenden Jahren infolge der Stilllegung von Kohle- und Atomkraftwerken ein Blindleistungspotenzial von 51,7 Gvar (eigene Berechnungen auf Grundlage von Angaben der Bundesnetzagentur, Kraftwerksliste 2016), das durch alternative Quellen für Blindleistung ersetzt werden muss.

Zeitgleich mit der Stilllegung von Großkraftwerken vollzieht sich eine dynamische Entwicklung im Bereich der Elektromobilität, die allein in Deutschland bis zum Jahr 2020 eine Million Elektrofahrzeuge auf die Straße bringen soll. Jedes Fahrzeug benötigt einen zuverlässigen Zugang zu einer EVSE. Daher wird bis zum Jahr 2020 auch eine entsprechende Anzahl (d. h. etwa eine Million) von EVSE benötigt, die in den Wohn- bzw. Firmengebäuden der Nutzer der Fahrzeuge zu installieren sind.

Obwohl die Anwendung der EVSE für elektrische Straßenfahrzeuge auf absehbare Zeit dominieren wird, ist der Begriff Elektrofahrzeug in dieser Anmeldung breit auszulegen, er umfasst mit Rädern ausgestattete Straßen- und Geländefahrzeuge, außerdem aber auch mit Ketten oder Kufen ausgestattete Fahrzeuge sowie elektrisch betriebene Wasser- und Luftfahrzeuge. Dabei kann das Fahrzeug bemannt, unbemannt oder autonom zum Einsatz kommen.

Eine EVSE ist über eine Steck- oder Schraubverbindung permanent mit einem Niederspannungsnetz verbunden. Selbstverständlich kann die Steck- oder Schraubverbindung gelöst werden, was jedoch nur bei einem Umsetzen der EVSE an einen anderen Ort vorgesehen ist.

Kommerziell verfügbar sind EVSE mit den Anschlussleistungen 3,7 kW, 7,4 kW, 11 kW und 22 kW, z. B. die Produktlinie "EVlink" von Schneider Electric. Zur Wiederaufladung der Batterie eines Elektrofahrzeugs wird dessen Ladegerät mit einer EVSE verbunden. Der Begriff Batterie bezeichnet in dieser Anmeldung wiederaufladbare Batterien, üblicherweise als Akkumulatoren bezeichnet, die eine Vielzahl von Lade-/Entlade-Zyklen durchlaufen können. Der durchschnittliche Energieverbrauch eines Elektrofahrzeugs beträgt nur 10 kWh/Tag, sodass die Wiederaufladung der Batterie des Elektrofahrzeugs bei Verwendung einer 22-kW-EVSE in der Regel innerhalb von weniger als 30 Minuten abgeschlossen ist. Selbst wenn nur eine EVSE mit einer geringen Nennleistung von 3,7 kW zur Verfügung steht, ist der Ladevorgang, der mit einer Entnahme von Wirkleistung aus dem Netz verbunden ist, in der Regel in weniger als 3 h abgeschlossen. Die EVSE wird also mehr als 85 % der verfügbaren Zeit nicht für Ladevorgänge benötigt, ist aber auch in dieser Zeit mit dem Netz verbunden. Mehr als 20 h täglich befindet sich jede EVSE also in Betriebsbereitschaft, ohne jedoch genutzt zu werden.

Die gleichzeitige Durchführung von Ladevorgängen an einer Vielzahl von EVSE in einem Niederspannungsnetz bedingt eine hohe Last (z. B. 2,2 MW bei Wirkleistungsentnahme durch 100 22-kW-EVSE) und verursacht eine unerwünschte Absenkung der Netzspannung, die durch Gegenmaßnahmen reduziert werden muss, um die Netzstabilität jederzeit zu gewährleisten.

Die in dieser Anmeldung dargestellte Erfindung beinhaltet eine verblüffend einfache Lösung, die EVSE, welche während Ladevorgängen die Netzstabilität beeinträchtigen, in den Zeiten ohne Ladevorgang selbst wieder zur Stabilisierung des Netzes einzusetzen. Dadurch wird eine neue, Anwendungsmöglichkeit für die leistungsstarke und teure Infrastruktur der Elektromobilität erschlossen und die "Leerlaufzeit" dieser Infrastruktur, d. h. die Zeiten ohne Ladevorgänge, wirtschaftlich genutzt.

Die Grundidee der Erfindung besteht darin, eine Vorrichtung bereitzustellen, welche eine bisher nicht bekannte Kombination einer Stromversorgungseinrichtung für Elektrofahrzeuge (EVSE) mit einem Blindleistungsmodul beinhaltet. Die EVSE und das Blindleistungsmodul sind über genau einen elektrischen Stromknoten verbunden, sodass sie unabhängig voneinander betrieben werden können. Diese Vorrichtung ersetzt die bisher in der Infrastruktur der Elektromobilität vorgesehenen EVSE. Die Vorrichtung ist dazu ausgelegt, die Netzspannung am Netzverknüpfungspunkt der Vorrichtung zu messen, mit einem Sollwert zu vergleichen und Abweichungen vom Sollwert durch die Erzeugung und Einspeisung von Blindleistung am Netzverknüpfungspunkt zu reduzieren. Der dafür erforderliche Aufbau der beiden Komponenten EVSE und Blindleistungsmodul wird in den Ausführungsbeispielen detailliert beschrieben.

Die erfindungsgemäße Vorrichtung wird anstelle einer herkömmlichen EVSE in dem ausschließlich für die Elektromobilität vorgesehenen Strompfad einer Elektroinstallation positioniert. Ein ausschließlich für die Elektromobilität vorgesehener Strompfad wird in dieser Anmeldung als "expliziter Strompfad" bezeichnet und ist wie folgt zu verstehen:
Der Strompfad ist ausschließlich (explizit) für den Energieaustausch mit der Batterie eines Elektrofahrzeugs vorgesehen, der über eine EVSE und ein angeschlossenes Ladegerät erfolgt. Der explizite Strompfad ist auszulegen gemäß den jeweils geltenden gesetzlichen Normen, die in der Regel einen hohen Anschlussstrom vorschreiben. Die internationale Norm IEC 18015-1 und die deutsche Norm DIN EN 18015-1:2013-09 schreiben eine Dreiphasen-Wechselstromverbindung (Drehstromverbindung), ausgelegt für 32 A je Phase, vor. Bei einer Netzspannung von 400 V (verkettete Spannung) wird somit über die drei Phasen eines Drehstromanschlusses eine totale elektrische Leistung (Scheinleistung) von √3 x 400 V x 32 A = 22 kVA im expliziten Strompfad bereitgestellt, die dauerhaft für die Ladung, aber auch Entladung, der Batterie eines Elektrofahrzeugs zur Verfügung steht, jedoch im Normalbetrieb nur während weniger als 15 % der verfügbaren Zeit abgerufen wird.

Die im expliziten Strompfad positionierte erfindungsgemäße Vorrichtung kann somit über ihre EVSE bis zu 22 kW Wirkleistung P aus dem Niederspannungsnetz beziehen und an ein angeschlossenes Ladegerät eines Elektrofahrzeuges weiterleiten. In Zeiten ohne Wirkleistungsbezug (d. h. außerhalb von Ladevorgängen) kann die Vorrichtung über ihr Blindleistungsmodul eine induktive oder kapazitive Blindleistung Q mit demselben maximalen Betrag, d. h. eine kapazitive Blindleistung von - 22 kvar oder eine induktive Blindleistung von + 22 kvar, erzeugen und über den expliziten Strompfad in das Niederspannungsnetz einspeisen. Da beide Komponenten der Vorrichtung unabhängig voneinander, also auch gleichzeitig betreibbar sind, ist auch ein gleichzeitiger Bezug von Wirkleistung und Blindleistung Q realisierbar, wobei eine Scheinleistung *S* = (*P*² + *Q*²)^{0,5} = 22 kVA nicht überschritten werden kann. Wie einleitend erwähnt, entspricht die Einspeisung kapazitiver Blindleistung einem Bezug induktiver Blindleistung und umgekehrt.

Mit der erfindungsgemäßen Vorrichtung wird somit eine hochverfügbare 22-kvar-Blindleistungsquelle bereitgestellt, die über eine Elektroinstallation an ein Niederspannungsnetz anzuschließen ist. Werden im Rahmen des Markthochlaufs der Elektromobilität eine Million solcher Vorrichtungen (eine für jedes in Deutschland bis zum Jahr 2020 vorgesehene Elektrofahrzeug) installiert, so erreicht ihre summierte Blindleistung die Größenordnung des heute von Großkraftwerken bereitgestellten Blindleistungspotenzials.

Die einzelnen erfindungsgemäßen Vorrichtungen sind in der bisher beschriebenen Ausführung nur für unabhängige, lokale Regelvorgänge ausgelegt. Sie erfassen über eigene Messeinrichtungen lediglich den lokalen Zustand des Niederspannungsnetzes (Strom und Spannung) an ihrem Netzverknüpfungspunkt, ermitteln aus diesen Daten die lokal benötigte Blindleistungsmenge und optimieren durch die Einspeisung dieser Blindleistungsmenge den Zustand an ihrem Netzverknüpfungspunkt. Diese lokale Optimierung kann sich aber im Gesamtkontext des Niederspannungsnetzes und dessen vorgelagerten Netzebenen als unvorteilhaft oder sogar destruktiv erweisen. Eine solche unkoordinierte Einspeisung von Blindleistung kann also die Netzstabilität sogar herabsetzen.

Um die erfindungsgemäßen Vorrichtungen für eine koordinierte Blindleistungserzeugung und -regelung im Gesamtkontext des Niederspannungsnetzes und dessen vorgelagerten Netzebenen nutzen zu können, wird jede erfindungsgemäße Vorrichtung kommunikationsfähig ausgeführt. Die EVSE als eine Komponente der Vorrichtung ist gemäß der Norm IEC 61851-1 mit Kommunikationsmöglichkeiten auszustatten, falls ein Informationsaustausch erforderlich ist. Zur Regelung der Blindleistungseinspeisung im Gesamtkontext des Niederspannungsnetzes und dessen vorgelagerten Netzebenen ist zwingend eine Kommunikation in Richtung vom "Smart Grid" zum Blindleistungsmodul jeder Vorrichtung erforderlich. Dazu wird das Blindleistungsmodul jeder Vorrichtung als fernsteuerbares Blindleistungsmodul ausgeführt. Sowohl die EVSE als auch das fernsteuerbare Blindleistungsmodul sind über eine Kommunikationsverbindung mit dem Kommunikationsnetz des als "Smart Grid" ausgeführten Niederspannungsnetzes verbunden. Damit ist eine Kommunikation im Sinne eines bidirektionalen Datenaustauschs zwischen der EVSE und dem Blindleistungsmodul jeder Vorrichtung und dem "Smart Grid" gewährleistet.

Um eine koordinierte Blindleistungserzeugung und -regelung im Gesamtkontext des Niederspannungsnetzes und ggf. dessen vorgelagerten Netzebenen zu ermöglichen, werden mehrere erfindungsgemäße Vorrichtungen zu einer Gruppe, nachfolgend als Cluster bezeichnet, zusammengefasst, wobei sie über ihre Kommunikationsverbindungen und das Kommunikationsnetz des Smart Grids mit mindestens einer übergeordneten Instanz verbunden werden. Alle in einem Niederspannungsnetz vorhandenen erfindungsgemäßen Vorrichtungen können dem Cluster angeschlossen werden. In einem Sonderfall kann das Cluster aber auch nur eine einzige erfindungsgemäße Vorrichtung aufweisen.

Die übergeordnete Instanz dient der Koordinierung der Blindleistungserzeugung und -regelung durch die einzelnen erfindungsgemäßen Vorrichtungen im Gesamtkontext des Niederspannungsnetzes und ggf. seiner vorgelagerten Netzebenen. Sie ist ausgestattet mit Baugruppen
- zum Empfang von Messwerten, bei denen es sich um lokale Netzparameter (Strom und Spannung), die von den Messeinrichtungen der einzelnen erfindungsgemäßen Vorrichtungen und/oder weiteren im Niederspannungsnetz und ggf. seinen vorgelagerten Netzebenen verteilten Messsystemen übermittelt werden,
- zum Verbinden mit SCADA Supervisory Control and Data Acquisition oder anderen Netzleitsystemen zum Empfang von Anforderungen an den Netzbetrieb bzw. vorteilhaften Netzzustand,
- zur Analyse dieser Parameter und zur Berechnung der benötigten Blindleistung im Gesamtkontext des Niederspannungsnetzes und ggf. seiner vorgelagerten Netzebenen und zur Berechnung der für eine optimale Netzstabilität erforderlichen Blindleistungserzeugung und -regelung durch die einzelnen erfindungsgemäßen Vorrichtungen (individualisierte Blindleistungs-Einspeisebedarfe),
- zur Übermittlung dieser individualisierten Blindleistungs-Einspeisebedarfe an die fernsteuerbaren Blindleistungsmodule der einzelnen erfindungsgemäßen Vorrichtungen, die deren Erzeugung, Einspeisung und Regelung gewährleisten.

Diese Aufgaben werden in definierten, aber variablen Zeitintervallen unterbrechungsfrei nacheinander durchgeführt. Während des jeweils aktuellen Zeitintervalls werden die individualisierten Blindleistungs-Einspeisebedarfe in Form einer Blindleistungs-Zeit-Funktion, *Q*(*t*), für das nachfolgende definierte Zeitintervall berechnet und an die einzelnen erfindungsgemäßen Vorrichtungen übermittelt. Die Blindleistungs-Zeit-Funktionen, *Q(t),* können im Einzelfall für ein definiertes Zeitintervall einen konstanten Wert Q vorgeben, sind aber in der Regel zeitabhängig.

Abhängig von den gemessenen Netzparametern, Anforderungen und Netzzustand kann das definierte Zeitintervall angepasst werden. Hat sich z. B. ein in zwei aufeinanderfolgenden Zeitintervallen gemessener Netzparameter (Strom *I*(*t*) oder Spannung *U*(*t*)) stark geändert (indem die Differenz der Messwerte z. B. einen vorgegebenen Schwellwert übersteigt), so wird das definierte Zeitintervall verkürzt. Sind dagegen alle in zwei aufeinanderfolgenden Zeitintervallen gemessenen Netzparameter nahezu konstant geblieben (indem die Differenz ihrer Messwerte z. B. einen vorgegebenen Schwellwert unterschreitet), so wird das definierte Zeitintervall verlängert.

Die Datenübertragung zwischen der übergeordneten Instanz und den erfindungsgemäßen Vorrichtungen erfolgt bevorzugt über die Kommunikationsverbindungen des Smart Grids, welche gegenwärtig realisiert sind mittels Fernwirkprotokoll über Funkkommunikation oder leitungsgebundener Kommunikation, in Zukunft auch durch Powerline Communication = PowerLAN. Jede erfindungsgemäße Vorrichtung erhält somit von der übergeordneten Instanz ihre individualisierten Betriebsdaten für das jeweils folgende definierte Zeitintervall. Die erfindungsgemäßen Vorrichtungen werden somit durch die übergeordnete Instanz im Gesamtkontext des Niederspannungsnetzes und ggf. seiner vorgelagerten Netzebenen gesteuert. Dieser Steuervorgang wird in jedem Zeitintervall wiederholt, um jederzeit die optimale Blindleistungsmenge im Netz zu erzeugen und auszuregeln.

Diese zentrale Regelung ersetzt die oben beschriebene nachteilige lokale Regelung durch die erfindungsgemäßen Vorrichtungen selbst. Bei Ausfall der Kommunikationsverbindungen kann diese lokale Regelung in Form eines Notbetriebs wieder aufgenommen werden. Durch diese übergeordnete Instanz wird es möglich, eine koordinierte, auf den Status des gesamten Netzes abgestimmte, Blindleistungseinspeisung an den Netzverknüpfungspunkten der einzelnen erfindungsgemäßen Vorrichtungen zu realisieren. Eine destruktive Interaktion der erfindungsgemäßen Vorrichtungen wird zuverlässig vermieden. Durch diese koordinierte Blindleistungserzeugung und -regelung wird eine optimale Stabilisierung des Niederspannungsnetzes ermöglicht.

Die hierarchische Struktur, umfassend mindestens eine übergeordnete Instanz und ein Cluster, aufweisend mindestens eine erfindungsgemäße Vorrichtung, bildet über die Kommunikationsverbindungen des Smart Grids (ausgeführt z. B. als Netzwerkleitungen mit angeschlossenen Messsystemen bzw. Smart Meter) ein virtuelles Blindleistungs-Kraftwerk. Ein Smart Meter ist ein intelligentes Messsystem zur Erfassung elektrischer Größen, das über eine Messeinrichtung und eine Einbindung in ein Kommunikationsnetz verfügt.

Der Begriff "virtuelles Kraftwerk" ist in dieser Anmeldung in der folgenden, dem Fachmann bekannten Weise, zu verstehen: Ein virtuelles Kraftwerk ist eine Zusammenschaltung von dezentral verteilten Stromerzeugungseinheiten zu einem Cluster, das elektrische Leistung zuverlässig bereitstellen und damit die Leistung aus Großkraftwerken ersetzen kann. Das Attribut "virtuell" besagt, dass das Kraftwerk nicht an einen festen Standort gebunden ist, sondern aus einem Cluster dezentraler Anlagen besteht. Der Begriff "Kraftwerk" unterstreicht, dass seine Anschlussleistung bei Bedarf dauerhaft und unterbrechungsfrei zur Verfügung steht.

Das in dieser Anmeldung beschriebene virtuelle Blindleistungskraftwerk umfasst somit ein Cluster mit beliebig vielen dezentralen, über eine beliebig wählbare Fläche verteilten, erfindungsgemäßen Vorrichtungen, die blindleistungsfähig sind.

Es ist dem Cluster zu jedem Zeitpunkt eine ausreichende Anzahl erfindungsgemäßer Vorrichtungen angeschlossen, sodass die von dem virtuellen Blindleistungskraftwerk zu liefernde Blindleistung hochverfügbar ist, d. h. zuverlässig zur Verfügung steht.

Um dem Cluster zur Verfügung zu stehen, ist die erfindungsgemäße Vorrichtung, aufweisend eine Kombination aus einer EVSE und einem fernsteuerbaren Blindleistungsmodul, permanent mit einem als Smart Grid ausgeführten Niederspannungsnetz verbunden, wobei diese Verbindung zumindest eine Stromverbindung (gegeben durch einen expliziten Strompfad für die Elektromobilität) und eine Kommunikationsverbindung aufweist. Die erfindungsgemäße Vorrichtung ersetzt zum einen eine herkömmliche Stromversorgungseinrichtung für Elektrofahrzeuge, an der die Batterie eines Elektrofahrzeugs über ein geeignetes Ladegerät aufladbar ist, zum anderen wird durch die Ausstattung der erfindungsgemäßen Vorrichtung mit einem fernsteuerbaren Blindleistungsmodul die im Aufbau befindliche leistungsstarke Infrastruktur der Elektromobilität für eine zentral koordinierte und hochverfügbare Blindleistungserzeugung und -regelung für ein Niederspannungsnetz und ggf. seine vorgelagerten Netzebenen nutzbar. Der Zusammenschluss der einzelnen erfindungsgemäßen Vorrichtungen, die blindleistungsfähige Einheiten darstellen, zu einem Cluster erfolgt durch eine übergeordnete Instanz, die mittels Kommunikationsverbindungen zwischen ihr und den blindleistungsfähigen Einheiten ein virtuelles Blindleistungskraftwerk bildet. Das virtuelle Blindleistungskraftwerk umfasst somit mindestens eine übergeordnete Instanz, mindestens eine erfindungsgemäße Vorrichtung sowie die Kommunikationsverbindungen zwischen der übergeordneten Instanz und den erfindungsgemäßen Vorrichtungen.

Das virtuelle Blindleistungskraftwerk ist in der Lage, den zeitlichen und last- bzw. einspeisebedingten komplexen Anforderungen an den Blindleistungsbedarf eines Netzsegments, einer Netzebene oder netzebenenübergreifend, also im Gesamtkontext des Niederspannungsnetzes und ggf. seiner vorgelagerten Netzebenen sowie seiner Wechselwirkungen, mit einer hohen Zuverlässigkeit gerecht zu werden, d. h. die erforderliche Blindleistung hochverfügbar für ein Netzsegment, eine Netzebene oder netzebenenübergreifend bereitzustellen.

Unter einer Netzebene ist in dieser Anmeldung ein Bereich des gesamten elektrischen Energieversorgungssystems zu verstehen, der durch eine konstant zu haltende elektrische Nennspannung gekennzeichnet ist. Dem Fachmann bekannte Netzebenen sind Niederspannungsnetze, Mittelspannungsnetze, Hochspannungsnetze und Höchstspannungsnetze. Unter Netzsegment ist in dieser Anmeldung ein Teil einer Netzebene, also ein Teil eines Nieder- (Spannung ≤ 1 kV), Mittel- (Spannung >1 kV bis ≤ 36 kV), Hoch- (Spannung > 36 kV bis ≤ 150 kV) oder Höchstspannungsnetzes (Spannung > 150 kV) zu verstehen. Der Begriff "netzebenenübergreifend" bezeichnet in dieser Anmeldung einen mehrere Netzebenen, die unterschiedliche Nennspannungen aufweisen, übergreifenden Bereich.

Es ist dem Fachmann bekannt, dass Wirk- und Blindleistung in der Praxis stets gekoppelt auftreten. Das virtuelle Blindleistungskraftwerk ist zwar auf die unterbrechungsfreie Bereitstellung von Blindleistung ausgerichtet, jedoch nimmt es als Verbraucher unvermeidlich auch eine geringe Menge von Wirkleistung aus dem Niederspannungsnetz auf. Durch eine unten erläuterte optionale Ausstattung der erfindungsgemäßen Vorrichtungen mit einem Umrichter erhält es zudem die Möglichkeit, als Lieferant von Wirkleistung für ein Niederspannungsnetz zu fungieren. In dieser Ausführungsform ist es als virtuelles Kraftwerk (für Blind- und Wirkleistung) zu charakterisieren.

Die wesentlichen Komponenten der erfindungsgemäßen Vorrichtung, d. h. die EVSE und das Blindleistungsmodul, werden nachfolgend kurz beschrieben.

Eine EVSE ist gemäß der internationalen Norm IEC 61851-1, in Deutschland in Kraft als DIN EN 61851-1:2012-01 "Elektrische Ausrüstung von Elektro-Straßenfahrzeugen - Konduktive Ladesysteme für Elektrofahrzeuge", auszuführen. Gemäß dieser Norm umfasst sie "Leiter, einschließlich Außenleiter, Neutralleiter, Schutzerdungsleiter (PE-Leiter), Elektrofahrzeug-Steckvorrichtung, Anschlussstecker und sämtliches anderes Zubehör, Steckdosen oder Einrichtungen, die speziell zum Zweck der Energielieferung von der Hausverkabelung zum Elektrofahrzeug installiert wurden und die Kommunikation zwischen diesen gestattet falls erforderlich."

Ein Blindleistungsmodul umfasst zumindest eine Blindleistungsquelle, eine Blindleistungsregeleinheit, eine Messeinheit, eine Auswerteeinheit, eine Eingabe-/Ausgabeeinheit für Sollwerte und Back-Up-Werte von Betriebsdaten sowie von der Messeinheit erfasste und von der Auswerteeinheit berechnete Istwerte, wobei die Blindleistungsregeleinheit eine Recheneinheit mit hinterlegten Algorithmen zur Verarbeitung von Soll-, Ist- und Back-Up-Werten von Betriebsdaten aufweist. In dieser Ausführungsform ist es nur für die lokale, unkoordinierte Blindleistungserzeugung und -regelung geeignet.

Algorithmen sind definierte Handlungs- oder Rechenvorschriften und werden verwendet, um z. B. Netzzustände, (Blindleistungs-)Optima oder Betriebsdaten unter Berücksichtigung von Anforderungen, die im Sinne des Algorithmus als Nebenbedingungen verstanden werden, zu ermitteln oder aus Vorgaben (z. B. Betriebsdaten oder Back-Up-Werten) bestimmte Handlungen, z. B. eine Ansteuerung der Blindleistungsquelle, umzusetzen.

Die Algorithmen laufen als Programme der elektronischen Datenverarbeitung z. B. in der übergeordneten Instanz oder z. B. dem Blindleistungsmodul ab.

Die Ermittlung des Netzzustandes kann in der übergeordneten Instanz beispielsweise unter Zuhilfenahme einer Lastflussberechnung u. a. mittels Newton-Verfahren bzw. Newton-Raphson-Verfahren erfolgen.

Zur Ermittlung der optimalen Blindleistungserzeugung und -regelung (Betriebsdaten) jeder Vorrichtung im betrachteten virtuellen Blindleistungskraftwerk mit den entsprechenden Anforderungen können in der übergeordneten Instanz Algorithmen zur Optimierung eingesetzt werden. Lösungen können über bekannte Optimierungsverfahren wie z. B. das Quasi-Newton-Verfahren oder z. B. das Partikel-Schwarm-Verfahren erfolgen.

Im Blindleistungsmodul erfolgt beispielsweise die Abarbeitung von Betriebsdaten oder die Generierung von Back-Up-Werten nach entsprechend definierten Handlungs- oder Rechenvorschriften, die den Algorithmus bilden, als Programm innerhalb einer elektronischen Datenverarbeitung.

Ein fernsteuerbares Blindleistungsmodul für die koordinierte Blindleistungserzeugung und -regelung im Gesamtkontext eines Niederspannungsnetzes und ggf. seiner vorgelagerten Netzebenen, umfasst zusätzlich eine Blindleistungssteuereinheit mit einer Recheneinheit mit hinterlegten Algorithmen zur Verarbeitung von Soll-, Ist- und Back-Up-Werten von Betriebsdaten und ein Kommunikationsmodul.

Das Blindleistungsmodul ist zur Bereitstellung entweder induktiver oder kapazitiver Blindleistung oder induktiver und kapazitiver Blindleistung ausgelegt. Es ist möglich, die Blindleistungsregeleinheit und die Blindleistungssteuereinheit in einer einzigen Einheit zu vereinigen.

Die im Blindleistungsmodul enthaltene Blindleistungsquelle kann diskret schaltbar oder kontinuierlich einstellbar sein. Eine diskret schaltbare Blindleistungsquelle kann in einfacher Form durch mindestens ein diskretes blindleistungsfähiges Bauelement, z. B. eine Spule oder einen Kondensator, beide vorzugsweise schaltbar, oder eine elektronische Schaltung, umfassend mehrere blindleistungsfähige Bauelemente, z. B. eine Kondensatorbank, ausgeführt sein. Eine kontinuierlich einstellbare Blindleistungsquelle kann beispielsweise durch einen Blindleistungsstromrichter oder eine als Phasenschieber ausgeführte Synchronmaschine gebildet werden. Ein Blindleistungsstromrichter wird z. B. in G. Hagmann: "Leistungselektronik", 4. Auflage, S. 245ff (AULA-Verlag, 2009) beschrieben. Kombinationen diskret schaltbarer und kontinuierlich einstellbarer Ausführungsformen sind ebenfalls möglich.

Die erfindungsgemäße Vorrichtung, aufweisend eine neuartige Kombination aus einer EVSE und einem fernsteuerbaren Blindleistungsmodul, sowie das virtuelle Blindleistungskraftwerk eröffnen einen neuen Lösungsweg zur Stabilisierung eines Niederspannungsnetzes und seiner vorgelagerten Netzebenen. Sie erschließen einen Synergieeffekt zwischen dem Gebiet der Elektromobilität und dem Gebiet der intelligenten Netze (Smart Grids). Die Erfindung, umfassend die erfindungsgemäße Vorrichtung und das virtuelle Blindleistungskraftwerk, behebt den absehbaren zukünftigen Mangel an koordinierter und hochverfügbarer Blindleistungserzeugung und -regelung. Entscheidend dafür sind folgende Merkmale: Das Blindleistungsmodul und die EVSE der erfindungsgemäßen Vorrichtung sind unabhängig voneinander betreibbar. Somit kann das Blindleistungsmodul zur Blindleistungserzeugung und -regelung eingesetzt werden, ohne dass mindestens ein Ladegerät eines Elektrofahrzeugs an die EVSE der Vorrichtung angeschlossen ist. Das Blindleistungsmodul ist sogar besonders vorteilhaft einzusetzen, wenn die Elektrofahrzeuge unterwegs sind, nicht über die EVSE mit dem elektrischen Netz verbunden sind oder zwar verbunden sind, jedoch keinen Ladevorgang durchlaufen, denn es kann in diesem Fall seine volle Blindleistung bereitstellen, die bestimmt wird durch die Auslegung des expliziten Strompfads für die Elektromobilität (mit 22 kVA Anschlussleistung gemäß den anerkannten Regeln der Technik).

Die anerkannten Regeln der Technik bezeichnen in dieser Anmeldung die für einen bestimmten Standort gültigen Standards und Normen, die von allen beteiligten Akteuren zwingend einzuhalten sind. Im internationalen Rahmen sind das die IEC 18015-1 und die bereits erwähnte IEC 61851-1, welche auch in der Europäischen Union als EN 18015 -1 und EN 61851-1 gültig sind. In Deutschland sind sie zum Zeitpunkt dieser Anmeldung als DIN EN 18015-1:2013-09 "Elektrische Anlagen in Wohngebäuden - Teil 1: Planungsgrundlagen" und DIN EN 61851-1:2012-01 "Elektrische Ausrüstung von Elektro-Straßenfahrzeugen - Konduktive Ladesysteme für Elektrofahrzeuge" in Kraft.

Die erfindungsgemäße Vorrichtung und das erfindungsgemäße virtuelle Blindleistungskraftwerk sind ohne Weiteres so ausführbar, dass sie diesen Normen und zukünftigen Aktualisierungen derselben entsprechen, ebenso sind sie ohne Weiteres an ausländische Normen anzupassen.

Pro Wohngebäude, das mit einer Infrastruktur für Elektrofahrzeuge nach den anerkannten Regeln der Technik ausgestattet ist, d. h. einem expliziten 22-kVA-Strompfad, stehen durch die Erfindung 22 kvar Blindleistungspotential zur Verfügung. In Verbindung mit den kurzfristigen Zielen der deutschen Bundesregierung (eine Million Elektrofahrzeuge bis zum Jahr 2020 auf deutschen Straßen) ergibt sich, wenn die erfindungsgemäße Vorrichtung durchgehend in jeder Gebäudeinfrastruktur für Elektrofahrzeuge zum Einsatz gebracht wird, ein Blindleistungspotential als Cluster von 22,5 Gvar. Das entspricht etwa 44 % der derzeitigen koordinierten, hochverfügbaren Blindleistung durch konventionelle Großkraftwerke in Höhe von 51,7 Gvar (bei Betrachtung der aktuell installierten konventionellen Kraftwerksleistung in Deutschland und einer vereinheitlichten Annahme der Blindleistungsfähigkeit gemäß der Technischen Anschlussbedingungen Hochspannung, Mittelspannung und Niederspannung). Stattet man alle 18,7 Mio. Wohngebäude in Deutschland mit einer erfindungsgemäßen Vorrichtung aus, dann ergibt sich ein Blindleistungspotential als Cluster von 411,4 Gvar, welches etwa dem Achtfachen der derzeit von Großkraftwerken bereitgestellten koordinierten und hochverfügbaren Blindleistungserzeugung und -regelung entspricht. Die erfindungsgemäße Kombination einer Stromversorgungseinrichtung für Elektrofahrzeuge mit einem fernsteuerbaren Blindleistungsmodul zu einem Gerät (erfindungsgemäße Vorrichtung) und die Bildung eines virtuellen Blindleistungskraftwerks, aufweisend ein Cluster aus mehreren erfindungsgemäßen Vorrichtungen, einer übergeordneten Instanz und geeigneten Kommunikationsverbindungen ermöglichen es, die leistungsstarke Gebäudeinfrastruktur nach den anerkannten Regeln der Technik, die für das Laden von Elektrofahrzeugen in Gebäuden benötigt wird, für eine koordinierte, hochzuverlässige Blindleistungsbereitstellung und -regelung zu benutzen (Synergieeffekt).

Elektrofahrzeuge benötigen meist weniger Leistung als nach den anerkannten Regeln der Technik (z. B. Norm IEC 61851-1) verlangt und dann auch nur für eine kurze Zeit bezogen auf den ganzen Tag. Dadurch, dass die erfindungsgemäße Vorrichtung an der Gebäudeinstallation, die permanent mit dem Netz verbunden ist, angeschlossen ist, wird durch die erfindungsgemäße Vorrichtung ein hochverfügbares Blindleistungspotential bereitgestellt. Neben der hohen Verfügbarkeit und dem hohem Blindleistungspotential kommt eine hohe Regelgenauigkeit der Blindleistung hinzu. Das entstandene Cluster, ein virtuelles Blindleistungskraftwerk zur Blindleistungserzeugung und -regelung, wird dazu durch mindestens eine übergeordnete Instanz im Gesamtkontext des zu regelnden Netzes zentral koordiniert. Der Betreiber des virtuellen Blindleistungskraftwerks, beispielsweise ein Netzbetreiber, kann nach seinen Betriebs- und Netzanforderungen das zu regelnde Netz oder getrennt voneinander zu regelnde Netze definieren. Über die Anwendung von Kommunikation des virtuellen Blindleistungskraftwerks mit der entsprechenden übergeordneten Instanz können die zu regelnden Cluster variabel gebildet werden. Es wird möglich, zentral koordiniert und hochzuverlässig die jeweils zeitliche und last- bzw. einspeisebedingte Blindleistung für ein oder mehrere Netzsegmente, eine oder mehrere Netzebenen oder netzebenenübergreifend zu erzeugen und zu regeln. Dabei erfolgt die Blindleistungserzeugung und -regelung immer im Gesamtkontext des elektrischen Energieversorgungssystems und seiner Wechselwirkungen.

Dies ist ein Vorteil gegenüber den anderen vorhandenen Technologien, für die gilt: Dezentrale blindleistungsfähige Energieerzeugungsanlagen verwenden die Blindleistungseinspeisung, um den wirkleistungsbedingten Spannungsanstieg an ihrem Netzverknüpfungspunkt zu reduzieren. Blindleistungsfähige Ladegeräte von Elektrofahrzeugen kompensieren eine Spannungsabsenkung, die durch das zu ladende Elektrofahrzeug als große elektrische Last entsteht, durch den Bezug von kapazitiver Blindleistung lokal am Anschlusspunkt des Ladegerätes. Als Regelgröße wird in diesen Fällen die Spannung am jeweiligen Netzverknüpfungspunkt verwendet oder ein fester Blindleistungswert. Dies schließt eine Blindleistungsregelung im Kontext mit dem Gesamtnetz aus und kann sogar zu destruktiven Regelvorgängen im Netz führen.

Die Erfindung nutzt den Vorteil, dass der verwendete Strompfad für Elektromobilität, z. B. in der Gebäudeinstallation, nach den anerkannten Regeln der Technik auf Dauerleistung ausgelegt ist und somit auch für die Bereitstellung von Blindleistung zur Verfügung steht. Die Erfindung ermöglicht es, unabhängig von der Nutzung des Elektrofahrzeuges sowie dessen Ladegeräts, zentral koordiniert und hochverfügbar Blindleistung zu erzeugen und zu regeln. D. h., die Blindleistungserzeugung und -regelung ist unabhängig davon, ob ein internes oder externes Ladegerät vorhanden ist sowie davon, ob das Elektrofahrzeug unterwegs, ohne Verbindung mit dem elektrischen Netz geparkt oder geparkt und mit dem elektrischen Netz verbunden ist. Dies gilt ebenfalls bei mehreren Ladegeräten und Elektrofahrzeugen in allen sich ergebenden Kombinationen.

Im Falle von Ausfällen der Kommunikation kann zudem die Blindleistungserzeugung und - regelung auf lokal in den Geräten hinterlegte Back-Up-Werte mit entsprechenden Algorithmen zurückgreifen, die einen Notbetrieb basierend auf gesammelten Erfahrungswerten jedes Gerätes in Verbindung mit lokalen Messwerten garantiert. Ebenso können die Back-Up-Werte und die entsprechenden Algorithmen durch die übergeordnete Instanz vorgegeben werden. Unter Erfahrungswerten sind Ersatzwerte zu verstehen, die anstelle nicht vorliegender Betriebsdaten verwendet werden und aus vorangegangenen, vergleichbaren Zeitintervallen ermittelt werden oder als Standardwerte durch die übergeordnete Instanz vorgegeben werden. Lokale Messwerte werden von Elektrizitätszählern oder intelligenten Messsystemen am Ort der Vorrichtung oder in der Messeinheit der Vorrichtung erfasst. Lokal gemessen werden die Spannung *U* und der Strom *I* als Funktionen der Zeit *t.* Daraus lassen sich weitere elektrische Größen wie Wirkleistung *P*, Blindleistung *Q*, Leistungsfaktor cos ϕ und Frequenz *f* usw. errechnen.

Die Erfindung wird nachfolgend durch Abbildungen und Ausführungsbeispiele näher erläutert.

### Kurze Beschreibung der Abbildungen

**Fig. 1****:** Von der erfindungsgemäßen Vorrichtung erschlossene Synergien zwischen ihren Anwendungsgebieten "Elektrisches Energienetz (intelligente Netze / Smart Grids)" und "Elektromobilität".
**Fig. 2a****:** Schema einer Infrastruktur, in der die erfindungsgemäße Vorrichtung als ortsfestes oder ortsveränderliches Gerät verwendbar ist.
**Fig. 2b****:** Schema einer Infrastruktur gemäß Fig. 2a unter Berücksichtigung verschiedener Alternativen zum Anschluss verschiedener Formen von Ladegeräten und eines Elektrofahrzeugs an die erfindungsgemäße Vorrichtung.
**Fig. 3a****:** Darstellung der erfindungsgemäßen Vorrichtung für den am häufigsten zu erwartenden Einbaufall (Gebäudeinstallation mit Infrastruktur für Elektromobilität nach den anerkannten Regeln der Technik) mit entsprechender Peripherie zum Betrieb in einem virtuellen Blindleistungskraftwerk.
**Fig. 3b****:** Darstellung der erfindungsgemäßen Vorrichtung für den am häufigsten zu erwartenden Einbaufall (Gebäudeinstallation mit Infrastruktur für Elektromobilität nach den anerkannten Regeln der Technik) mit entsprechender Peripherie zum Betrieb in einem virtuellen Blindleistungskraftwerk und unter Verwendung eines externen Ladegerätes.
**Fig. 4a****:** Detaillierte Darstellung der erfindungsgemäßen Vorrichtung an dem am häufigsten zu erwartenden Einbauort (Gebäudeinstallation mit Infrastruktur für Elektromobilität nach den anerkannten Regeln der Technik) mit entsprechender Peripherie zum Betrieb in einem virtuellen Blindleistungskraftwerk.
**Fig. 4b****:** Detaillierte Darstellung der erfindungsgemäßen Vorrichtung an dem am häufigsten zu erwartenden Einbauort (Gebäudeinstallation mit Infrastruktur für Elektromobilität nach den anerkannten Regeln der Technik) mit entsprechender Peripherie zum Betrieb in einem virtuellen Blindleistungskraftwerk und dem Anschluss verschiedener Ladegerätvarianten an die Erfindung.
**Fig. 4c****:** Schematische Darstellung der erfindungsgemäßen Vorrichtung mit detaillierter Darstellung des Blindleistungsmoduls.
**Fig. 4d****:** Schematische Darstellung eines Blindleistungsmoduls mit einer detailliert dargestellten Blindleistungsregeleinheit.
**Fig. 4e****:** Schematische Darstellung eines Blindleistungsmoduls mit einer detailliert dargestellten Blindleistungssteuereinheit.

### Detaillierte Beschreibung der Abbildungen

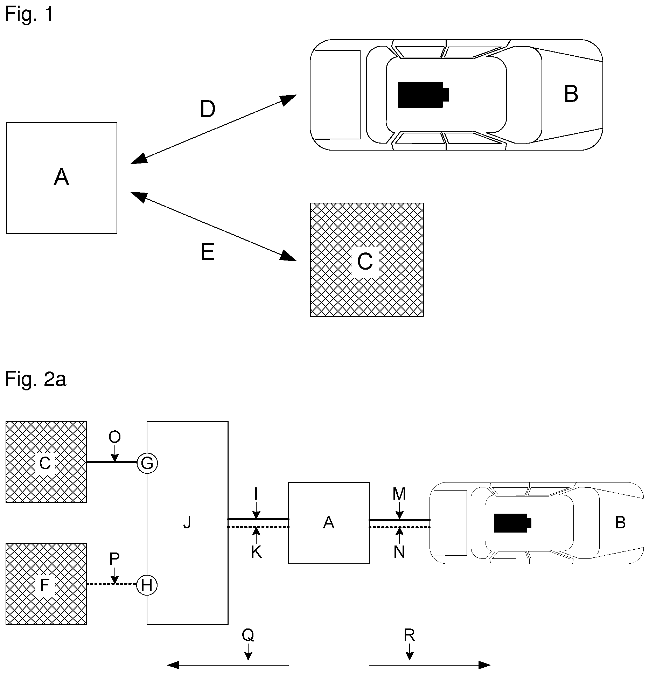

Die erfindungsgemäße Vorrichtung kombiniert eine Stromversorgungseinrichtung für Elektrofahrzeuge (EVSE) mit einem zentral koordinierbaren und regelbaren Blindleistungsmodul. In **Fig. 1** wird die durch die Erfindung entstehende Synergie schematisch verdeutlicht. Durch die erfindungsgemäße Vorrichtung A wird über eine Wechsel- oder Drehstromstromverbindung der Bezug und die Abgabe von Wirkleistung D als Stromversorgungseinrichtung für mindestens ein Elektrofahrzeug B, das beispielsweise über ein internes Ladegerät zur Aufladung einer Batterie (veranschaulicht durch ein Batteriesymbol) verfügt, realisiert. Zudem wird durch die erfindungsgemäße Vorrichtung A für das elektrische Energienetz C eine zentral koordinierte, hochverfügbare und geregelte Erzeugung von Blindleistung E bereitgestellt. Die erfindungsgemäße Vorrichtung A bildet somit eine Blindleistungsquelle für das elektrische Energienetz C.

In **Fig. 2a** wird das Schema einer Infrastruktur, in der die erfindungsgemäße Vorrichtung als ortsfestes (z. B. verschraubtes) oder ortsveränderliches (z. B. mit Steckverbindungen ausgestattetes) Gerät verwendbar ist, dargestellt.

Betrachtet man das Schema einer Infrastruktur, in der die erfindungsgemäße Vorrichtung A als ortsfestes oder ortsveränderliches Gerät verwendbar ist, so existieren zwei Betrachtungsrichtungen:
- Q: Betrachtungsrichtung von der erfindungsgemäßen Vorrichtung A zum elektrischen Energienetz C
- R: Betrachtungsrichtung von der erfindungsgemäßen Vorrichtung A zum Elektrofahrzeug B

Entlang der Betrachtungsrichtung Q ist die erfindungsgemäße Vorrichtung A über eine elektrische ortsveränderliche oder ortsfeste Wechsel- oder Drehstromverbindung I mit einer Elektroinstallation J verbunden, welche ihrerseits über den Netzverbindungspunkt G und die elektrische Netzanschlussleitung O mit einem elektrischen Niederspannungsnetz C verbunden ist. Unter der Elektroinstallation J ist zum Beispiel eine Gebäudeinstallation, Parkplatzstromverteilung, Tiefgaragenelektroinstallation, Niederspannungsverteilung, ein Schaltschrank oder am Straßenrand platzierter Anschlusskasten für mindestens eine öffentliche Stromversorgung für Elektrofahrzeuge einschließlich aller elektrischer Mess- und Betriebsmittel der Gebäudeinstallation zu verstehen. Die erfindungsgemäße Vorrichtung ist somit universell im Innen- oder Außenbereich einsetzbar.

Zudem verläuft ebenso entlang der Betrachtungsrichtung Q eine ortsveränderliche oder ortsfeste Kommunikationsverbindung K von der erfindungsgemäßen Vorrichtung A über den Netzverbindungspunkt H und einen Kommunikationspfad P zu einem dem Niederspannungsnetz C zugehörigen Kommunikationsnetz F. Die ortsveränderliche oder ortsfeste Kommunikationsverbindung K, sofern sie nicht per Funk erfolgt, wird hin zum Kommunikationsnetz F räumlich innerhalb oder außerhalb der Elektroinstallation J verlegt. Aufgrund seiner Ausstattung mit einem Kommunikationsnetz F stellt das Niederspannungsnetz C ein intelligentes Netz (Smart Grid) dar.

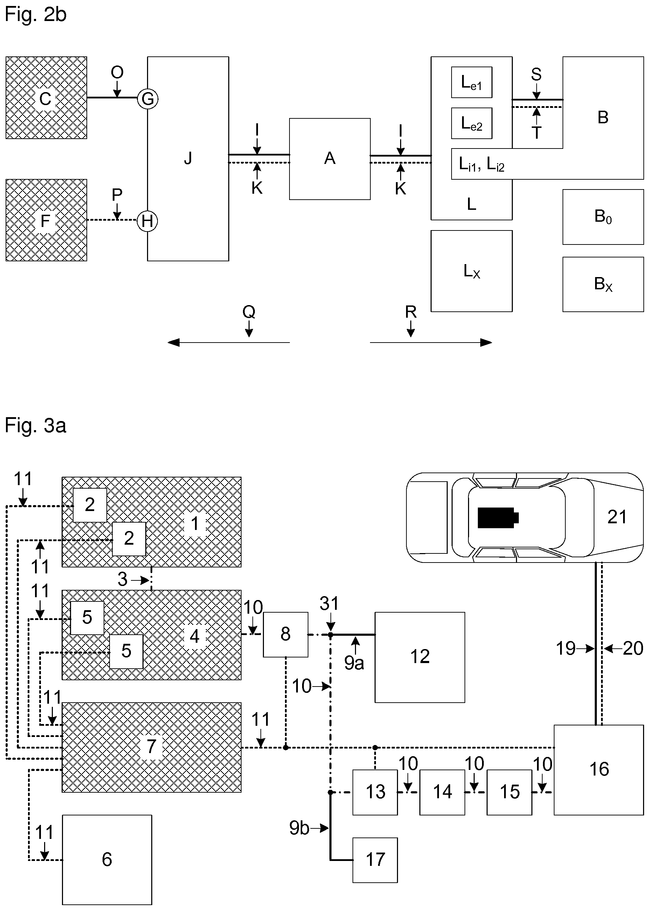

Entlang der Betrachtungsrichtung R ist die erfindungsgemäße Vorrichtung A über eine trennbare Wechsel- oder Drehstromverbindung für Lade- bzw. Entladeenergie M mit mindestens einem Elektrofahrzeug B verbindbar. Um die Batterie eines Elektrofahrzeuges (Gleichstromspeicher) mit dem elektrischen Netz (Wechsel- oder Drehstromnetz) zu verbinden, wird ein Umrichter (im Kontext mit der Elektromobilität üblicherweise als Ladegerät bezeichnet) benötigt, d. h. an der trennbaren Wechsel- oder Drehstromverbindung für Lade- bzw. Entladeenergie M hin zum Elektrofahrzeug B wird mindestens ein Ladegerät, beispielsweise ein im Elektrofahrzeug B fest installiertes Ladegerät (internes Ladegerät), benötigt. Ein am Ort der Infrastruktur J befindliches Ladegerät (da nicht im Elektrofahrzeug B installiert, als externes Ladegerät bezeichnet) ist ebenfalls verwendbar. Das Ladegerät, welches somit alle bekannten Ausführungsformen (intern oder extern, induktiv oder konduktiv) aufweisen kann, ist in Fig. 2a nicht dargestellt, wird aber unten in Bezug auf Fig. 2b ausführlich erläutert. In der erfindungsgemäßen Vorrichtung A befindet sich kein Umrichter (Ladegerät) für das Laden oder Entladen von Batterien in Elektrofahrzeugen; es handelt sich also um eine ladegerätlose Vorrichtung. Eine besondere Ausführungsform der erfindungsgemäßen Vorrichtung, in der diese mit einem Umrichter ausgestattet ist, wird unten beschrieben.

Zudem verläuft entlang der Betrachtungsrichtung R eine trennbare Kommunikationsverbindung zur Steuerung des Lade- bzw. Entladevorgangs N von der erfindungsgemäßen Vorrichtung A zum Elektrofahrzeug B, wie sie in den anerkannten Regeln der Technik für Stromversorgungseinrichtungen für Elektrofahrzeuge gefordert wird. Über die Kommunikationsverbindung N können Steuerbefehle an das Ladegerät des Elektrofahrzeugs B gegeben werden. Ebenso können vom Ladegerät Informationen über den Ladezustand der Batterie des Elektrofahrzeugs B an die erfindungsgemäße Vorrichtung A zurückgemeldet werden.

Die erfindungsgemäße Vorrichtung A nutzt den nach den anerkannten Regeln der Technik für die Elektromobilität vorgesehenen expliziten Strompfad, der für 32 A je Phase ausgelegt ist. Im Falle des Aufladens der Batterie eines Elektrofahrzeugs mit elektrischer Energie aus dem Netz oder dem Rückspeisen von elektrischer Energie aus der Batterie eines Elektrofahrzeugs in das Netz ohne zentral koordinierte und hochverfügbare Blindleistungserzeugung und -regelung erfolgt über die Aufeinanderfolge von elektrischem Energienetz C, der elektrischen Netzanschlussleitung O, dem Netzverbindungspunkt zum elektrischen Energienetz G, der Elektroinstallation J, der ortsveränderlichen oder ortsfesten Wechsel- oder Drehstromverbindung I, der erfindungsgemäßen Vorrichtung A und der trennbaren Wechsel- oder Drehstromverbindung für Lade- bzw. Entladeenergie M zum Elektrofahrzeug B ein Wirkleistungsbezug aus dem oder eine Wirkleistungsabgabe in das elektrische Niederspannungsnetz C.

Sobald die erfindungsgemäße Vorrichtung A zentral koordinierte und hochverfügbare Blindleistungserzeugung und -regelung bereitstellt, stellt sich über die Aufeinanderfolge von elektrischem Energienetz C über die elektrische Netzanschlussleitung O, den Netzverbindungspunkt G, die Elektroinstallation J, die ortsveränderliche oder ortsfeste Wechsel- oder Drehstromverbindung I bis zur erfindungsgemäßen Vorrichtung A ein induktiver oder kapazitiver Blindstrom ein. Das Blindleistungsmodul der erfindungsgemäßen Vorrichtung A wirkt ausschließlich in Betrachtungsrichtung von der erfindungsgemäßen Vorrichtung A zum elektrischen Energienetz (Betrachtungsrichtung Q). Die Elemente in Betrachtungsrichtung von der erfindungsgemäßen Vorrichtung zum Elektrofahrzeug (Betrachtungsrichtung R), d. h. die trennbare Wechsel- oder Drehstromverbindung für Lade- bzw. Entladeenergie M und das Elektrofahrzeug B werden von der erfindungsgemäßen Vorrichtung A nicht mit Blindleistung belastet.

Die Kommunikation in der Aufeinanderfolge von Kommunikationsnetz F, Kommunikationspfad zwischen Kommunikationsnetz und Netzverbindungspunkt P, Netzverbindungspunkt zum Kommunikationsnetz H, i. d. R. bei leitungsgebundenem Kommunikationspfad (elektrisch oder optisch) der Elektroinstallation J, ortsveränderlicher oder ortsfester Kommunikationsverbindung K, erfindungsgemäßer Vorrichtung A, trennbarer Kommunikationsverbindung für den Lade- bzw. Entladevorgang N und dem Elektrofahrzeug B beispielhaft mit einem internen Ladegerät kann in einzelnen Abschnitten oder in ihrer Gesamtheit elektrisch, optisch oder per Funk erfolgen.

In **Fig. 2b** ist das Schema der Infrastruktur gemäß **Fig. 2a** unter Berücksichtigung verschiedener Alternativen zum Anschluss verschiedener Formen von Ladegeräten und eines Elektrofahrzeuges dargestellt.

Die Infrastruktur selbst, d. h. von der erfindungsgemäßen Vorrichtung A in Betrachtungsrichtung von der erfindungsgemäßen Vorrichtung zum elektrischen Netz Q, wurde bereits durch **Fig. 2a** beschrieben. Nachfolgend werden daher nur die verschiedenen Alternativen zum Anschluss verschiedener Ausführungsarten eines Ladegerätes L mit einem Elektrofahrzeug B erläutert.

Es besteht die Möglichkeit, die erfindungsgemäße Vorrichtung A mit folgenden Ausführungsarten von Ladegeräten L über eine ortsveränderliche oder ortsfeste Wechsel- oder Drehstromverbindung I zu verbinden:
- externes konduktives Ladegerät Lₑ₁
- externes induktives Ladegerät Lₑ₂
- internes konduktives Ladegerät L₁
- internes induktives Ladegerät Lᵢ₂

Die Anzahl der Ladegeräte L und Elektrofahrzeuge B kann größer als 1 sein. Ist die Wechsel- oder Drehstromverbindung I als Drehstromverbindung ausgeführt, so kann ein einziges Ladegerät L eines Elektrofahrzeugs B an deren drei Phasen angeschlossen werden. Ebenso kann aber an jede der drei Phasen jeweils ein Ladegerät L eines Elektrofahrzeugs B angeschlossen werden, sodass die Batterien dreier Elektrofahrzeuge gleichzeitig geladen werden.

Interne Ladegeräte L₁, Lᵢ₂ sind im Elektrofahrzeug verbaut und werden mitbewegt, wohingegen externe Ladegeräte Lₑ₁, Lₑ₂ am Ort der Infrastruktur verbleiben. Für externe Ladegeräte Lₑ₁, Lₑ₂ erfolgt der Anschluss an ein Elektrofahrzeug B über einen trennbaren Energiepfad S, der eine Wechsel- oder Drehstromverbindung, eine elektromagnetische Kopplung (zum induktiven Laden) oder eine Gleichstromverbindung sein kann.

Ebenso besteht die Möglichkeit, dass kein Ladegerät vorhanden ist oder ein vorhandenes Ladegerät nicht mit dem elektrischen Netz verbunden ist; dieser Anwendungsfall wird als Lx symbolisiert. Ferner bestehen die Möglichkeiten, dass kein Elektrofahrzeug vorhanden ist (durch Bx symbolisiert) oder dass ein Elektrofahrzeug vorhanden, aber nicht an einem Ladegerät angeschlossen ist (durch B₀ symbolisiert). Eine Blindleistungsfähigkeit der Ladegeräte ist nicht notwendig. Es ist für die Funktionsfähigkeit der erfindungsgemäßen Vorrichtung völlig unerheblich, ob ein Ladegerät an die erfindungsgemäße Vorrichtung angeschlossen ist, und, falls das der Fall ist, ob dieses Ladegerät eine Blindleistungsfähigkeit aufweist oder nicht.

Die Kommunikation von der erfindungsgemäßen Vorrichtung A zu internen Ladegeräten Lᵢ₁, L₂ führt über eine ortsveränderliche oder ortsfeste Kommunikationsverbindung K. Für externe Ladegeräte Lₑ₁, Lₑ₂ schließt sich nach dem Ladegerät L ein trennbarer Kommunikationspfad für den Lade- bzw. Entladevorgang T an.

in **Fig. 3a** ist der am häufigsten erwartete Einbaufall der erfindungsgemäßen Vorrichtung innerhalb einer Gebäudeinstallation als detaillierteres Schema dargestellt. Die erfindungsgemäße Vorrichtung 16 dient zum Anschluss eines oder mehrerer Elektrofahrzeuge 21 und kann zentral koordinierte und hochverfügbare Blindleistungserzeugung und -regelung innerhalb eines virtuellen Blindleistungskraftwerks zur Verfügung stellen.

Nach den anerkannten Regeln der Technik ist die Netzanschlussleitung für den beispielhaften Einbauort als Drehstromverbindung für eine Belastung von mindestens 63 A pro Phase für den Anschluss über einen Elektrizitätszähler oder ein intelligentes Messsystem 8 mit dem Niederspannungsnetz 4 herzustellen. Die Netzanschlussleitung teilt sich hinter dem Elektrizitätszähler oder dem intelligenten Messsystem 8 in einem Stromknoten 31 auf. Ein Strompfad führt zum Stromverteiler der allgemeinen Gebäudeversorgung 12 und ist ein Strompfad ohne Blindleistungsregelung 9a. Vom Stromknoten 31 führt ein weiterer, blindleistungsfähiger, Strompfad 10, welcher ein expliziter Strompfad ist, über einen separaten Elektrizitätszähler oder intelligentes Messsystem für Ladeenergie (Bezug und Abgabe) und Blindenergie 13, einer Fehlerstrom-Schutzeinrichtung 14, und einem Leitungsschutzschalter 15 zur erfindungsgemäßen Vorrichtung 16. Sie ersetzt eine gewöhnliche Stromversorgungseinrichtung für Elektrofahrzeuge. Über eine trennbare Wechsel- oder Drehstromverbindung 19 ist mit der erfindungsgemäßen Vorrichtung 16 mindestens ein Elektrofahrzeug 21 mit einem Ladegerät, das intern oder extern sowie konduktiv oder induktiv ausgeführt sein kann, angebunden. Dieser eben beschriebene explizite Strompfad für die Elektromobilität ist nach den anerkannten Regeln der Technik mit einer dauerhaften Strombelastbarkeit von 3 x 32 A auszulegen, woraus eine Anschlussleistung für die Elektromobilität von 22 kVA resultiert. Dieser explizite Strompfad kann für eine hochverfügbare Blindleistungsbereitstellung genutzt werden, wie die folgende Abschätzung zeigt: Nach eigenen Untersuchungen von statistischen Daten zur durchschnittlichen Nutzung von Fahrzeugen steht diese Leistung zu 85 % des Tages für die volle Blindleistungsübertragung von 22 kvar zur Verfügung. Lediglich während 15 % des Tages ist die Blindleistungserzeugung und -regelung aufgrund von Ladevorgängen (Wirkleistungsbezug) eingeschränkt. Daraus folgt, dass dieser Strompfad für zentral koordinierte und hochverfügbare Blindleistungserzeugung und -regelung verwendet werden kann.

In der erfindungsgemäßen Vorrichtung 16 wird Blindleistung erzeugt, geregelt und über den Strompfad mit Blindleistungsregelung 10 dem Niederspannungsnetz 4 zugänglich gemacht. Über eine Verbindung zwischen den Netzen 3 kann die im Niederspannungsnetz 4 bereitgestellte Blindleistung in vorgelagerte Netzebenen 1 übertragen werden. Der Strompfad mit Blindleistungsregelung 10 stellt die Verbindung zwischen der erfindungsgemäßen Vorrichtung 16 und dem Niederspannungsnetz 4 über die weiteren Komponenten Elektrizitätszähler oder intelligentes Messsystem 8, Elektrizitätszähler oder intelligentes Messsystem für Ladeenergie (Bezug, in besonderen Fällen, z. B. Netzengpässen, auch Abgabe von Wirkleistung) und Blindenergie 13, einer Fehlerstrom-Schutzeinrichtung 14 und Leitungsschutzschalter 15 her. Nicht involviert für zentral koordinierte und hochverfügbare Blindleistungserzeugung und -regelung sind die Stromverteilung für die allgemeine Gebäudeversorgung 12 einschließlich deren Verbindung als Strompfad ohne Blindleistungsregelung 9a bis zum Stromknoten 31 in Richtung des Elektrizitätszählers oder intelligenten Messsystems 8. Ebenso wird die trennbare Wechsel- oder Drehstromverbindung 19 in Richtung des Elektrofahrzeugs 21 mit Ladegerät sowie der Strompfad ohne Blindleistungsregelung 9b zum Anschluss der Überspannungs-Schutzeinrichtung Typ 2 17 nicht für die Blindleistungserzeugung oder -regelung genutzt. Blindenergie ist als Zeitintegral der Blindleistung definiert.

Jeweils zeitlich begrenzte Lade- oder Entladevorgänge, die zu einer Teilauslastung des Strompfads mit Blindleistungsregelung 10 führen können, werden bei der Berechnung der Betriebsdaten für die erfindungsgemäße Vorrichtung 16 berücksichtigt. Im Fall von Netzengpässen oder Netzstörfällen kann eine Unterbrechung von Lade- oder Entladevorgängen vorgenommen werden. Dies wird durch die übergeordnete Instanz 6 bei der Berechnung der Betriebsdaten jeder erfindungsgemäßen Vorrichtung im Cluster berücksichtigt.

Sind mehrere erfindungsgemäße Vorrichtungen 16 im elektrischen Netz installiert, so kann mittels Bildung einer Gruppe (Clustern) dieser Vorrichtungen 16 und über die Kommunikation des Smart Grids ein virtuelles Blindleistungskraftwerk aufgebaut werden. Der Betreiber des virtuellen Blindleistungskraftwerks kann beispielsweise der Netzbetreiber sein. Er erfasst durch Messeinrichtungen 2 im vorgelagerten elektrischen Netzsystem 1, Messeinrichtungen 5 im Niederspannungsnetz 4, Elektrizitätszähler oder intelligente Messsysteme 8 und Elektrizitätszähler oder intelligente Messsysteme für Ladeenergie (Bezug und Abgabe) und Blindenergie 13 Informationen über den Netzzustand. Über Kommunikationsverbindungen 11 sind diese Geräte mit dem Kommunikationsnetz 7 elektrisch, optisch oder drahtlos und aus Kombinationen dieser verbunden. Ebenso ist am Kommunikationsnetz 7 über mindestens eine Kommunikationsverbindung 11 eine übergeordnete Instanz 6 angebunden. Die übergeordnete Instanz 6 bildet die zentrale Regeleinheit des virtuellen Blindleistungskraftwerks und berechnet auf Grundlage der über das Kommunikationsnetz erhaltenen Informationen sowie mittels Algorithmen den Netzzustand (z. B. Auslastung der Betriebsmittel, Spannungswerte usw.) für mindestens ein Netzsegment, mindestens eine Netzebene oder netzebenenübergreifend. Der Netzzustand beschreibt die Situation in einem elektrischen Netz bezogen auf Auslastung von Betriebsmitteln, Spannungswerte, Lastflüsse usw. Der Netzzustand kann über Lastflussberechnungen ermittelt werden. Unter Berücksichtigung der Anforderungen an den Netzbetrieb, einschließlich des aktuellen Netzzustandes, der Anforderungen von Betreibern vorgelagerter Netze und der Anforderungen an das virtuelle Blindleistungskraftwerk und der Kunden bzw. Partner des Betreibers des virtuellen Blindleistungskraftwerks, berechnet die übergeordnete Instanz 6 die erforderliche Blindleistung für das entsprechende Netzsegment als Betriebsdaten für ein definiertes Zeitintervall. Betriebsmittel umfassen elektrische Geräte, Baugruppen oder Bauelemente wie Schalter, Sicherungen, Einrichtungen zur Überwachung und Steuerung, Leitungen und Transformatoren.

Über das Kommunikationsnetz 7 erhält jede Vorrichtung 16 im virtuellen Blindleistungskraftwerk ihre entsprechenden Betriebsdaten für das nachfolgende definierte Zeitintervall. In definierten Zeitintervallen wird dieser geschlossene Regelvorgang kontinuierlich wiederholt, um die optimale Blindleistungsmenge für das entsprechende Netz bzw. Netzsegment zu erzeugen und zu regeln. Die definierten Zeitintervalle können konstante oder zeitveränderliche Intervalle sein. Die spezifisch für jede erfindungsgemäße Vorrichtung 16 im virtuellen Blindleistungskraftwerk ermittelten Betriebsdaten werden nicht als statischer Betriebspunkt übermittelt. D. h., dass die Betriebsdaten nicht als statischer Wert (Betriebspunkt für einen definierten Zeitabschnitt) zu verstehen sind, sondern als eine Blindleistungs-Zeit-Funktion *Q*(*t*) mit beliebigem Verlauf, also in Form eines kontinuierlichen Betriebsbereichs. Der Sonderfall eines statischen Werts, d. h. *Q*(*t*)=konstant über das jeweilige Zeitintervall, ist natürlich enthalten. Die berechneten Betriebsdaten ermöglichen den optimalen Betrieb des virtuellen Blindleistungskraftwerks nach den jeweiligen Anforderungen an die Blindleistung. Zudem schließen die Messwerte in Verbindung mit den Algorithmen über die übergeordnete Instanz 6 den kontinuierlichen Regelkreis. Der kontinuierliche Regelkreis besteht u. a. aus der übergeordneten Instanz 6, die Anforderungen als Führungsgrößen und rückgeführte Messwerte aus dem Netz erhält, und der erfindungsgemäßen Vorrichtung 16, die von der übergeordneten Instanz berechnete Betriebsdaten erhält und damit Blindleistung erzeugt und regelt.

Die Anforderungen an den Netzbetrieb können u. a. die Optimierung der Auslastung der Betriebsmittel durch Blindleistungsregelung und die damit verbundene Verlustminimierung, Optimierung des Leistungsfaktors für einen bestimmten Netzpunkt (Netzverknüpfungspunkt bzw. Übergabestelle zum vorgelagerten Netzbetreiber) oder Spannungshaltung sein. Zudem werden die Anforderungen der vorgelagerten Netzbetreiber sowie Kunden bzw. Partner des Betreibers des virtuellen Blindleistungskraftwerks oder Netzbetreibers hierarchisch berücksichtigt. Deren Anforderungen können auch netzdienliche Anforderungen hinsichtlich der Beseitigung von Netzengpässen oder Netzstörfällen sein. Die Informationen über die entsprechenden Anforderungen werden ebenfalls über Kommunikationsnetze 7 übertragen; dies bedeutet i. d. R. die Anbindung von Netzleitsystemen bzw. Supervisory Control and Data Acquisition (SCADA) u. a. mittels Fernwirkprotokollen. SCADA bezeichnet das Überwachen, Steuern und Regeln von Prozessen mittels eines computerbasierenden Systems. Die Netzleittechnik elektrischer Energienetze ist ein Leitsystem gemäß SCADA. Fernwirkprotokolle sind Kommunikationsstandards innerhalb von Netzleitsystemen, z. B. nach den Normen IEC 60870, IEC 61850 oder nach DNP3.

Die Kommunikation innerhalb des Smart Grids über die Kommunikationsverbindungen 11 erfolgt i. d. R. bidirektional. Eine unidirektionale Kommunikation kann beispielsweise für die Übertragung von Messwerten aus Messeinrichtungen im vorgelagerten elektrischen Netzsystem 2 oder Messeinrichtungen im Niederspannungsnetz 5 über das Kommunikationsnetz 7 zur übergeordneten Instanz 6 ebenfalls vorkommen.

Die trennbare Kommunikationsverbindung 20 zwischen der erfindungsgemäßen Vorrichtung 16 und dem Elektrofahrzeug 21 und dessen Ladegerät dient der Erfüllung der anerkannten Regeln der Technik hinsichtlich der Schutz-, Lade- und Entladefunktionen. In die zentral koordinierte und hochverfügbare Blindleistungserzeugung und -regelung ist diese trennbare Kommunikationsverbindung 20 nicht eingebunden.

Für die Beschreibung der erfindungsgemäßen Vorrichtung 16 allgemein und des am häufigsten erwarteten Anwendungsfalls eines Elektrofahrzeuges 21 mit internem Ladegerät ist

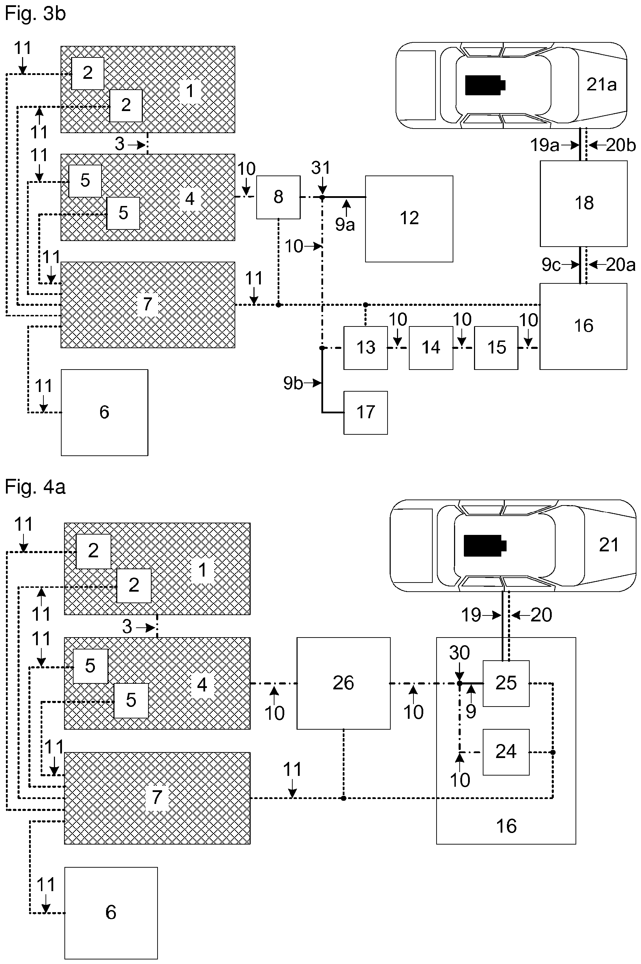

**Fig. 3a** hinreichend aussagekräftig. In **Fig. 3b** wird die erfindungsgemäße Vorrichtung 16 in Verbindung mit einem externen Ladegerät 18 zusätzlich dargestellt.

Die Verwendung eines externen Ladegerätes, wie in **Fig. 3b** gezeigt, wirkt sich nicht auf die Infrastruktur vor der erfindungsgemäßen Vorrichtung 16 aus. Das betrifft die Komponenten, Pfade und Verbindungen, die sich direkt oder indirekt an die erfindungsgemäße Vorrichtung 16 über den Strompfad mit Blindleistungsregelung 10 oder die Kommunikationsverbindung 11, die elektrisch, optisch oder per Funk aufgebaut sein kann, anschließen. Von der erfindungsgemäßen Vorrichtung 16 in Richtung des Elektrofahrzeuges zum Anschluss an ein externes Ladegerät 21 a führt ein Strompfad ohne Blindleistungsregelung 9c zum externen Ladegerät 18. Das externe Ladegerät 18 wird mit einer trennbaren Wechsel- oder Drehstromverbindung, elektromagnetischen Kopplung (induktiven Kopplung) oder Gleichstromverbindung 19a mit dem Elektrofahrzeug zum Anschluss an ein externes Ladegerät 21 a verbunden.

Bezüglich der Kommunikation führt von der erfindungsgemäßen Vorrichtung 16 ein Kommunikationspfad zur Steuerung des externen Ladegeräts 20a zum externen Ladegerät 18, das konduktiv oder induktiv ausgeführt sein kann. Zwischen dem externen Ladegerät 18 und dem Elektrofahrzeug zum Anschluss an ein externes Ladegerät 21 a befindet sich ein trennbarer Kommunikationspfad für den Lade- bzw. Entladevorgang 20b. Die Kommunikation kann elektrisch, optisch oder per Funk bzw. durch Kombinationen der drei Arten erfolgen.

**Fig. 4a** zeigt eine Detaildarstellung der erfindungsgemäßen Vorrichtung 16 an ihrem am häufigsten zu erwartenden Einbauort (Gebäudeinstallation mit Infrastruktur für Elektromobilität nach den anerkannten Regeln der Technik) und die erforderliche Peripherie zu ihrem Betrieb in einem virtuellen Blindleistungskraftwerk.

Die erfindungsgemäße Vorrichtung 16 kombiniert eine Stromversorgungseinrichtung für Elektrofahrzeuge 25 nach den anerkannten Regeln der Technik, bekannt als Electric Vehicle Supply Equipment (EVSE), mit einem fernsteuerbaren Blindleistungsmodul 24. Die EVSE stellt für das Laden oder Entladen von mindestens einem Elektrofahrzeug eine Wechsel- oder Drehstromverbindung 19 nach den anerkannten Regeln der Technik zur Verfügung. An die Wechsel- oder Drehstromverbindung 19, die je nach Anschlussfall aus einem an der erfindungsgemäßen Vorrichtung 16 festinstallierten Kabel mit (Norm-)Stecker oder einer (Norm-)Steckdose zum Anschluss eines Ladekabels bestehen kann, wird zwischen der Stromversorgungseinrichtung für Elektrofahrzeuge 25 und dem Elektrofahrzeug 21 selbst ein Ladegerät als Umrichter benötigt. Als Beispiel wird davon ausgegangen, dass das Elektrofahrzeug 21 mit einem internen Ladegerät ausgestattet ist. Die Stromversorgungseinrichtung für Elektrofahrzeuge 25 ist über einen Strompfad ohne Blindleistungsregelung 9 mit dem Strompfad mit Blindleistungsregelung 10 über einen Stromknoten 30 verbunden. Ein Stromknoten stellt eine elektrische Verzweigung im Sinne des 1. Kirchhoffschen Satzes dar.

Des Weiteren beinhaltet die erfindungsgemäße Vorrichtung 16 ein fernsteuerbares Blindleistungsmodul 24. Dieses ist als Blindleistungsquelle für kapazitive und induktive Blindleistung zu verstehen. Die technische Ausführung als Blindleistungsquelle kann nach den heutigen verfügbaren Technologien (z. B. diskrete Bauelemente, elektronische Schaltungen, Synchronmaschine als Phasenschieber oder Kombinationen daraus) bestehen. Grundsätzlich kann die Blindleistung diskret oder kontinuierlich geregelt werden. Dabei ist eine Auslegung zu favorisieren, die eine kontinuierlich veränderliche kapazitive und induktive Blindleistungsregelung ermöglicht. Damit können in Form einer beliebigen Blindleistungs-Zeit-Funktion, *Q(t),* vorgegebene Betriebsdaten exakt umgesetzt werden.

Das fernsteuerbare Blindleistungsmodul 24 innerhalb der erfindungsgemäßen Vorrichtung 16 ist über den Strompfad für Blindleistungsregelung 10 mit dem Niederspannungsnetz 4 verbunden. Am fernsteuerbaren Blindleistungsmodul 24 beginnt der Strompfad mit Blindleistungsregelung 10 und geht über einen Stromknoten 30, an dem der Strompfad ohne Blindleistungsregelung 9 zur Stromversorgungseinrichtung für Elektrofahrzeuge 25 für Energiebezug und -abgabe abzweigt, zur Elektroinstallation 26, die beispielhaft die Gebäudeinstallation mit allen Mess- und Betriebsmitteln zusammenfasst. Von der Elektroinstallation 26 kann die im fernsteuerbaren Blindleistungsmodul 24 erzeugte Blindleistung über den Strompfad mit Blindleistungsregelung 10 in das Niederspannungsnetz 4 gelangen. Vom Niederspannungsnetz 4 kann die Blindleistung je nach Anforderung über die Verbindung zwischen den Netzen 3 in das vorgelagerte elektrische Netz 1 fließen.

Das fernsteuerbare Blindleistungsmodul 24 erhält innerhalb des virtuellen Blindleistungskraftwerks durch die übergeordnete Instanz 6 seine Betriebsdaten in definierten, aber zeitveränderlichen, Intervallen. Die übergeordnete Instanz 6 überträgt die Informationen, die für das jeweilige fernsteuerbare Blindleistungsmodul 24 ermittelt wurden, über mindestens eine Kommunikationsverbindung 11 an das Kommunikationsnetz 7. An diesem Kommunikationsnetz 7 sind neben den Messeinrichtungen im vorgelagerten elektrischen Netzsystem 2 und Messeinrichtungen im Niederspannungsnetz 5 auch über mindestens eine Kommunikationsverbindung 11 die Elektroinstallation 26, die beispielhaft die Gebäudeinstallation mit allen Mess- und Betriebsmitteln zusammenfasst, als auch die erfindungsgemäße Vorrichtung 16 angebunden. Innerhalb der erfindungsgemäßen Vorrichtung 16 setzt sich die Kommunikationsverbindung 11 fort. An ihm wird das fernsteuerbare Blindleistungsmodul 24 angebunden. Ebenso kann an der Kommunikationsverbindung 11 die Stromversorgungseinrichtung für Elektrofahrzeuge für Energiebezug und -abgabe 25 angebunden sein, um eine netzdienliche Steuerung zu realisieren. Die Kommunikationsverbindung 11 kann auch als Bestandteil der zusammengefassten Elektroinstallation 26 betrachtet werden und wäre in diesem Fall durch diese zu führen.

Für den Fall eines Kommunikationsausfalls bzw. einer Nicht-Erreichbarkeit des fernsteuerbaren Blindleistungsmoduls 24 mittels Kommunikation sind Back-Up-Algorithmen zur Blindleistungserzeugung und -regelung lokal im fernsteuerbaren Blindleistungsmodul 24 hinterlegt. Das Blindleistungsmodul 24 schaltet in einen Notbetrieb um, der entweder auf eigenen gesammelten Erfahrungswerten in Verbindung mit lokalen Messwerten oder auf zu einem früheren Zeitpunkt übermittelten Vorgabewerten der übergeordneten Instanz 6 basiert. In diesem Fall wird also auf eine nichtkoordinierte Blindleistungserzeugung und -regelung zurückgegriffen.

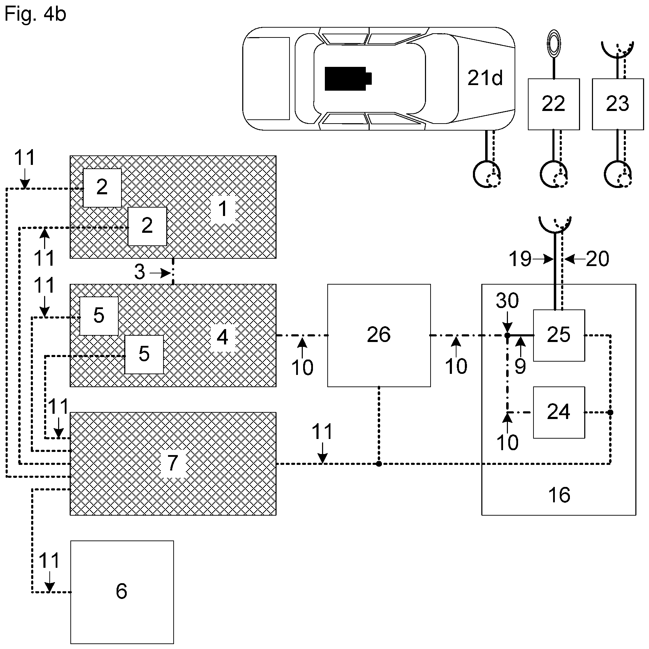

In der folgenden **Fig. 4b** wird der Anschluss von Ladegerätvarianten an die erfindungsgemäße Vorrichtung gemäß **Fig. 4a** beschrieben.

In **Fig. 4b** werden die trennbare Wechsel- oder Drehstromverbindung 19 und die trennbare Kommunikationsverbindung 20 zum Anschluss von Ladegeräten aufgezeigt. Die Möglichkeit der Trennbarkeit wird über eine oder mehrere Steckverbindungen gekennzeichnet, die die trennbare Wechsel- oder Drehstromverbindung 19 mit einem Elektrofahrzeug mit internem Ladegerät 21 d, einem externen induktiven Ladegerät 22 oder einem externen konduktiven Ladegerät 23 verbinden. Neben der eben beschriebenen energietechnischen Verbindung 19, d. h. der Verbindung für den Wirkleistungsaustausch, von der Stromversorgungseinrichtung für Elektrofahrzeuge für Energiebezug und -abgabe 25 ist die Kommunikation ebenso durch eine trennbare Kommunikationsverbindung 20 gewährleistet. Auch eine Funkverbindung wird hier als trennbare Kommunikationsverbindung verstanden. Die trennbare Kommunikationsverbindung 20 ermöglicht über eine oder mehrere Steckverbindungen oder Funk die Kommunikation zwischen der Stromversorgungseinrichtung für Elektrofahrzeuge für Energiebezug und -abgabe und dem Elektrofahrzeug mit internem Ladegerät 21 d für den Lade- bzw. Entladevorgang. Zudem wird über die trennbare Kommunikation 20 die Steuerung des externen induktiven Ladegeräts 22 bzw. des konduktiven Ladegeräts 23 realisiert.

Es sei nochmals betont, dass die erfindungsgemäße Vorrichtung 16 in den vorab beschriebenen Ausführungsformen nicht mit einem Umrichter (Ladegerät) ausgestattet ist. Es handelt sich somit um eine ladegerätlose Vorrichtung. Durch den Verzicht auf einen Umrichter (Ladegerät) ist die erfindungsgemäße Vorrichtung 16 sehr kostengünstig ausführbar.
Für bestimmte Anwendungsfälle die kann Stromversorgungsvorrichtung erfindungsgemäße Vorrichtung 16 mit mindestens einem nicht dargestellten Umrichter (Stromrichter) ausgestattet sein, der mindestens eine der nachfolgenden nicht abschließend aufgezählten Anwendungen ermöglicht: Gleichrichten (Wechsel- oder Drehstrom in Gleichstrom umformen), Wechselrichten (Gleichstrom in Wechsel- oder Drehstrom umformen), Wechselstromumrichten (Wechsel- oder Drehstrom in Wechsel- oder Drehstrom mit anderer Spannung oder anderer Frequenz umformen), Gleichstromumrichten (Gleichstrom in Gleichstrom mit anderer Spannung oder anderer Polarität umformen) oder Oberschwingungskompensation. Über mindestens einen Umrichter ist somit der Wirkleistungsaustausch zwischen mindestens einer elektrischen Energiequelle (Wechsel-, Drehstrom- oder Gleichstrom) und mindestens einer elektrischen Energiesenke (Wechsel-, Drehstrom- oder Gleichstrom) möglich.

Über einen solchen Umrichter können folgende elektrische Energiequellen mit der erfindungsgemäßen Vorrichtung 16 verbunden werden: mindestens eine dezentrale Erzeugungsanlage, mindestens ein elektrischer Energiespeicher, die Batterie mindestens eines Elektrofahrzeuges 21 d, wobei der Umrichter als Ladegerät für das Elektrofahrzeug 21 d im Rahmen eines Entladevorgangs fungiert, oder ein Niederspannungsnetz. Dabei kann es sich um das Niederspannungsnetz 4 eines Netzbetreibers, aber auch um das Niederspannungsnetz innerhalb eines Grundstückes, eines Gebäudes (Hausnetz), einer Elektroinstallation usw. handeln. Ferner können über einen solchen Umrichter folgende elektrische Energiesenken mit der erfindungsgemäßen Vorrichtung 16 verbunden werden: mindestens ein elektrischer Energiespeicher, die Batterie mindestens eines Elektrofahrzeuges 21 d, wobei der Umrichter als Ladegerät für ein Elektrofahrzeug 21 d im Rahmen eines Ladevorgangs fungiert, oder ein Niederspannungsnetz. Die elektrische Energiequelle oder elektrische Energiesenke kann ebenso Teil der Elektroinstallation 26 oder des Stromverteilers für allgemeine Gebäudeversorgung 12 sein. Als elektrische Energiesenken sind auch verwendbar eine Batterieanordnung oder ein Elektrolyseur. Als elektrische Energiequellen sind auch verwendbar eine Batterieanordnung, eine Brennstoffzellenanordnung, eine Photovoltaikanlage oder eine Kleinwindkraftanlage. Batterieanordnungen können sein: Anordnungen von Redox-Flow-Batterien, Lithium-Batterien oder Blei-Batterien. Diese Aufzählungen elektrischer Energiequellen und Energiesenken sind nicht abschließend.
Als Verbindung zwischen mindestens einer elektrischen Energiesenke oder mindestens einer elektrischen Energiequelle mit der erfindungsgemäßen Vorrichtung 16 kann der Strompfad ohne Blindleistungsregelung 9, der Strompfad mit Blindleistungsregelung 10, eine trennbare Wechsel- oder Drehstromverbindung 19 oder eine trennbare Wechsel- oder Drehstromverbindung, elektromagnetische Kopplung oder Gleichstromverbindung (nur konduktiv) 19a verwendet werden. Diese Aufzählung ist nicht abschließend.

Die einfachste (nicht dargestellte) Ausführung eines Blindleistungsmoduls weist mindestens eine Blindleistungsquelle und mindestens eine Steuerung oder Regelung, die über mindestens eine Kommunikationsverbindung verfügt, auf. Mindestens eine Steuerung oder Regelung schaltet, steuert oder regelt mindestens eine Blindleistungsquelle, die aus mindestens einem Kondensator oder mindestens einer Spule oder einer Kombination aus mindestens einem Kondensator und mindestens einer Spule besteht. Kondensatoren, Spulen oder Kombinationen aus mindestens einem Kondensator und mindestens einer Spule können zu Gruppen zusammengefasst sein. Das Schalten, Steuern oder Regeln einzelner Elemente (Kondensator oder Spule) der Blindleistungsquelle, Gruppen der Elemente oder der Blindleistungsquelle als Gesamtheit erfolgt durch Schalter, Relais oder Elektronik, wobei diese Aufzählung nicht abschließend ist.

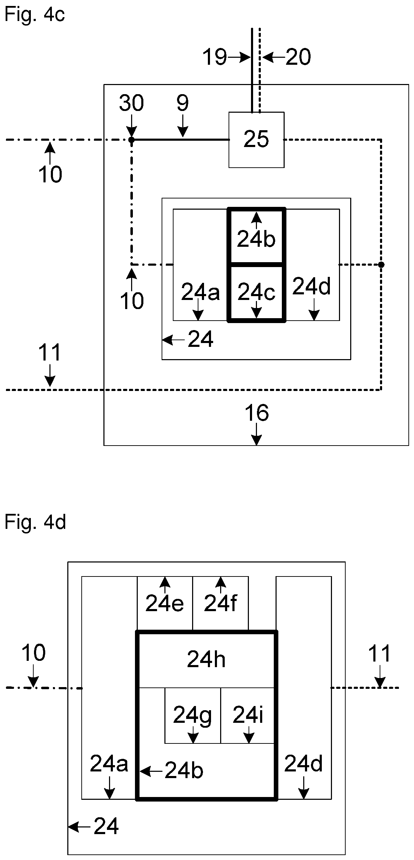

**Fig. 4c** zeigt eine schematische Darstellung der erfindungsgemäßen Vorrichtung 16, in welcher die einzelnen Baugruppen des Blindleistungsmoduls 24 detailliert dargestellt sind. Erkennbar ist Verbindung der EVSE 25 und des Blindleistungsmoduls 24 über den gemeinsamen Stromknoten 30. Das Blindleistungsmodul 24 weist eine Blindleistungsquelle 24a, eine Blindleistungsregeleinheit 24b oder eine Blindleistungssteuereinheit 24c und ein Kommunikationsmodul 24d auf. Die übrigen Elemente entsprechen denen in den vorangehenden Abbildungen.

**Fig. 4d** beinhaltet die Darstellung eines Blindleistungsmoduls 24 mit einer Blindleistungsregeleinheit 24b, deren Aufbau detailliert dargestellt ist. Die Blindleistungsregeleinheit 24b weist einen Datenspeicher 24g, eine Ein-/Ausgabeeinheit für Soll- und Backup-Werte von Betriebsdaten 24h und eine Recheneinheit 24i auf. Das Blindleistungsmodul 24 weist außerdem noch eine Messeinheit 24e und eine Auswerteeinheit 24f auf.

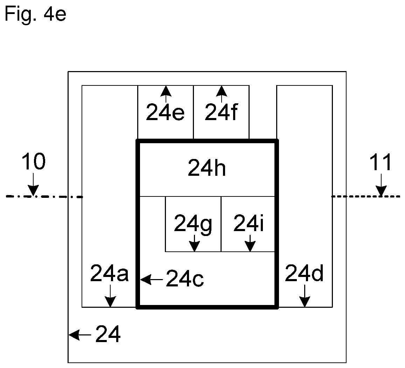

**Fig. 4e** beinhaltet die Darstellung eines Blindleistungsmoduls 24 mit einer Blindleistungssteuereinheit 24c, deren Aufbau detailliert dargestellt ist. Die Blindleistungssteuereinheit 24c weist einen Datenspeicher 24g, eine Ein-/Ausgabeeinheit für Soll- und Backup-Werte von Betriebsdaten 24h und eine Recheneinheit 24i auf. Das Blindleistungsmodul 24 weist außerdem noch eine Messeinheit 24e und eine Auswerteeinheit 24f auf.

### Gewerbliche Anwendbarkeit der Erfindung

Ein erfindungsgemäßes virtuelles Blindleistungskraftwerk wird in der Regel durch den Netzbetreiber realisiert, der aufgrund des hohen Bedarfs an Blindleistungserzeugung und -regelung keinerlei Probleme hat, die erzeugte Blindleistung mit angemessenem Gewinn zu vermarkten. Der Netzbetreiber kann seiner Verpflichtung zur Sicherung eines ordnungsgemäßen Netzbetriebs nachkommen, ohne eigene Investitionen für Blindleistungsregelanlagen aufbringen zu müssen.

Es sind jedoch noch weitere Zielgruppen für die gewerbliche Nutzung der Erfindung zu erkennen.

Fahrzeughersteller können die erfindungsgemäßen Vorrichtungen zusammen mit Elektrofahrzeugen verkaufen und zu einem Cluster aggregieren. In ähnlicher Weise können auch Gerätehersteller die erfindungsgemäßen Vorrichtungen (ohne Elektrofahrzeug) verkaufen und zu einem Cluster aggregieren. Fahrzeug- bzw. Gerätehesteller können dieses Cluster zur Blindleistungserzeugung und -regelung an einen Netzbetreiber übertragen oder selbst betreiben. Sie erweitern dadurch ihr Produktportfolio und erschließen für sich ein neues Geschäftsfeld als Blindleistungslieferant.

Letztendlich können auch die privaten Nutzer bzw. Besitzer eines Elektrofahrzeugs oder eines Gebäudes die in ihrem Besitz befindliche erfindungsgemäße Vorrichtung an ihren Netzbetreiber oder eine andere Zielgruppe vermieten und daraus Einnahmen erzielen. Die Informationen zur gewerblichen Anwendbarkeit der Erfindung werden in folgender (nicht abschließender) Tabelle zusammengefasst.

| **Zielgruppe** | **Anwendung** | **Benefit** |
|---|---|---|
| Geräte-Hersteller | baut und verkauft die erfindungsgemäßen Vorrichtungen | Erweiterung des Produktportfolios |
| | clustert als virtuelles Blindleistungskraftwerk mehrere erfindungsgemäße Vorrichtungen zur Blindleistungserzeugung und - regelung; zudem bietet er das virtuelle Blindleistungskraftwerk z. B. dem Netzbetreiber oder Stromhändler an | Eintritt in ein neues Geschäftsfeld als "Blindleistungslieferant" |
| Nutzer eines Elektrofahrzeuges | vermietet die Nutzung der erfindungsgemäßen Vorrichtung an seinen Netzbetreiber oder eine andere Zielgruppe | Einnahmen durch Vermietung der Nutzung der Erfindung |
| Fahrzeug-Hersteller | verkauft / vertreibt die erfindungsgemäße Vorrichtung mit seinem Elektrofahrzeug | Erweiterung der Produktportfolios |
| | aggregiert ein Cluster seiner verkauften /vertriebenen Vorrichtungen zur Blindleistungserzeugung und -regelung; zudem bietet er das virtuelle Blindleistungskraftwerk z. B. einem Netzbetreiber an | Eintritt in ein neues Geschäftsfeld als "Blindleistungslieferant" |
| Netzbetreiber | betreibt ein Cluster der erfindungsgemäßen Vorrichtungen als virtuelles Blindleistungskraftwerk der in seinem Netz zur Blindleistungserzeugung und -regelung kauft Blindleistungserzeugung und -regelung von einem anderen aus der eigenen oder anderen Zielgruppe | kommt seiner gesetzlichen Verpflichtung eines ordnungsgemäßen Netzbetriebs mit konformer Blindleistung nach kann Investitionen in eigene Blindleistungsregelanlagen vermeiden |
| Stromhändler | clustert mehrere Einheiten der erfindungsgemäßen Vorrichtung zu einem virtuellen Blindleistungskraftwerk zur Blindleistungserzeugung und -regelung; zudem bietet er das virtuelle Blindleistungskraftwerk z. B. einem Netzbetreiber an | Eintritt in ein neues Geschäftsfeld "Blindleistungslieferant" über Skalierung des Geschäftsfelder "Stromlieferant" |

### Bezugszeichenliste

A: erfindungsgemäße Vorrichtung
B: Anwendungsfall - Elektrofahrzeug ist vorhanden und verbunden
B₀: Anwendungsfall - Elektrofahrzeug ist vorhanden, aber nicht verbunden
Bx: Anwendungsfall - Elektrofahrzeug ist nicht vorhanden
C: elektrisches Energienetz (Niederspannungsnetz)
D: Bezug und Abgabe von Wirkleistung als Stromversorgungseinrichtung für Elektrofahrzeuge
E: zentral koordinierte, hochverfügbare und geregelte Bereitstellung von Blindleistung
F: Kommunikationsnetz
G: Netzverbindungspunkt zum elektrischen Energienetz (Niederspannungsnetz)
H: Netzverbindungspunkt zum Kommunikationsnetz
I: ortsveränderliche oder ortsfeste Wechsel- oder Drehstromverbindung
J: Elektroinstallation (beispielhaft für eine Gebäudeinstallation einschließlich aller elektrischen Mess- und Betriebsmittel)
K: ortsveränderliche oder ortsfeste Kommunikationsverbindung
L: Anwendungsfall - Ladegerät ist vorhanden
Lₑ₁: Anwendungsfall - externes konduktives Ladegerät ist vorhanden
Lₑ₂: Anwendungsfall - externes induktives Ladegerät ist vorhanden
Lᵢ₁: Anwendungsfall - internes konduktives Ladegerät ist vorhanden
Lᵢ₂: Anwendungsfall - internes induktives Ladegerät ist vorhanden
Lx: Anwendungsfall - Ladegerät ist nicht vorhanden
M: trennbare Wechsel- oder Drehstromverbindung für Lade- bzw. Entladeenergie
N: trennbare Kommunikationsverbindung zur Steuerung des Lade- bzw. Entladevorgangs
O: elektrische Netzanschlussleitung
P: Kommunikationspfad zwischen Kommunikationsnetz und Netzverbindungspunkt
Q: Betrachtungsrichtung von der erfindungsgemäßen Vorrichtung zum elektrischen Energienetz
R: Betrachtungsrichtung von der erfindungsgemäßen Vorrichtung zum Elektrofahrzeug
S: trennbarer Energiepfad (Wechsel- oder Drehstromverbindung, elektromagnetische Kopplung oder Gleichstromverbindung)
T: trennbarer Kommunikationspfad für den Lade- bzw. Entladevorgang

1: vorgelagerte elektrische Netzebenen
2: Messeinrichtungen im vorgelagerten elektrischen Netzsystem
3: Verbindung zwischen den Netzen
4: Niederspannungsnetz
5: Messeinrichtungen im Niederspannungsnetz
6: übergeordnete Instanz zur Berechnung der Betriebsdaten jeder Einheit (Erfindung) im Cluster
7: Kommunikationsnetz
8: Elektrizitätszähler oder intelligentes Messsystem
9, 9a, 9b, 9c: Strompfad ohne Blindleistungsregelung
10: Strompfad mit Blindleistungsregelung
11: Kommunikationsverbindung (elektrisch, optisch oder per Funk)
12: Stromverteiler für allgemeine Gebäudeversorgung
13: Elektrizitätszähler oder intelligentes Messsystem für Ladeenergie (Bezug und Abgabe) und Blindenergie
14: Fehlerstrom-Schutzeinrichtung
15: Leitungsschutzschalter
16: erfindungsgemäße Vorrichtung (ersetzt übliche Stromversorgungseinrichtung für Elektrofahrzeuge)
17: Überspannungs-Schutzeinrichtung Typ 2
18: externes Ladegerät (konduktiv oder induktiv)
19: Wechsel- oder Drehstromverbindung
19a: Wechsel- oder Drehstromverbindung oder Gleichstromverbindung (nur konduktiv)
20: trennbare Kommunikationsverbindung
20a: Kommunikationspfad zur Steuerung eines externen Ladegeräts
20b: trennbarer Kommunikationspfad zur Steuerung eines Lade- bzw. Entladevorgangs
21: Elektrofahrzeug mit Ladegerät (intern oder extern sowie konduktiv oder induktiv)
21 a: Elektrofahrzeug zum Anschluss an ein externes Ladegerät
21 d: Elektrofahrzeug mit internem Ladegerät
22: externes induktives Ladegerät
23: externes konduktives Ladegerät
24: Blindleistungsmodul, ggf. fernsteuerbar
24a: Blindleistungsquelle
24b: Blindleistungsregeleinheit
24c: Blindleistungssteuereinheit
24d: Kommunikationsmodul
24e: Messeinheit
24f: Auswerteeinheit
24g: Datenspeicher
24h: Ein-/Ausgabeeinheit für Soll- und Backup-Werte von Betriebsdaten
24i: Recheneinheit
25: Stromversorgungseinrichtung für Elektrofahrzeuge (EVSE) für Energiebezug und -abgabe
26: Elektroinstallation (beispielhaft für eine Gebäudeinstallation sowie alle elektrischen Mess- und Betriebsmittel)
30: Stromknoten, der die Stromversorgungseinrichtung für Elektrofahrzeuge (EVSE) 25 über einen Strompfad ohne Blindleistungsregelung 9 mit dem Strompfad mit Blindleistungsregelung 10 verbindet
31: Stromknoten, an dem sich die Netzanschlussleitung hinter dem Elektrizitätszähler oder dem intelligenten Messsystem 8 in einen Strompfad ohne Blindleistungsregelung 9a zum Stromverteiler der allgemeinen Gebäudeversorgung 12 und in einen expliziten Strompfad mit Blindleistungsregelung aufteilt

## Patentansprüche

1. Vorrichtung (A, 16), geeignet zum Austausch von Wirkleistung zwischen einer Batterie eines Elektrofahrzeugs (21, 21 a, 21 d) und einem Niederspannungsnetz und zur Bereitstellung von Blindleistung für ein Niederspannungsnetz, aufweisend eine Kombination aus einer Stromversorgungseinrichtung für Elektrofahrzeuge EVSE (25) und einem Blindleistungsmodul (24).

2. Vorrichtung (A, 16) nach Anspruch 1, **dadurch gekennzeichnet, dass** das Blindleistungsmodul (24) und die Stromversorgungseinrichtung für Elektrofahrzeuge EVSE (25) über genau einen gemeinsamen Stromknoten (30) verbunden sind, sodass sie unabhängig voneinander betreibbar sind.

3. Vorrichtung (A, 16) nach Anspruch 1 oder 2, **dadurch gekennzeichnet, dass** das Blindleistungsmodul (24) eine Blindleistungsquelle (24a), eine Blindleistungsregeleinheit (24b) oder eine Blindleistungssteuereinheit (24c) sowie mindestens ein Kommunikationsmodul (24d) umfasst.

4. Vorrichtung (A, 16) nach Anspruch 3, **dadurch gekennzeichnet, dass** das Blindleistungsmodul (24) fernsteuerbar ausgeführt ist, indem es mithilfe seines Kommunikationsmoduls (24d) über eine Kommunikationsverbindung (11) mit einem Kommunikationsnetz (7) verbindbar ist.

5. Vorrichtung (A, 16) nach einem der Ansprüche 1 bis 4, **dadurch gekennzeichnet, dass** das Blindleistungsmodul (24) eine Blindleistungsquelle (24a) mit einem oder mehreren diskreten Betriebspunkten oder eine Blindleistungsquelle (24a) mit mindestens einem kontinuierlichen Betriebsbereich aufweist.

6. Vorrichtung (A, 16) nach Anspruch 5, **dadurch gekennzeichnet, dass** die Blindleistungsquelle (24a) mit einem oder mehreren diskreten Arbeitspunkten durch mindestens einen Kondensator oder durch mindestens eine Spule oder durch Kombinationen dieser Komponenten gebildet wird, während die Blindleistungsquelle (24a) mit mindestens einem kontinuierlichen Arbeitsbereich durch einen Blindleistungsstromrichter oder durch eine als Phasenschieber fungierende Synchronmaschine oder durch Kombinationen dieser Komponenten gebildet wird.

7. Vorrichtung (A, 16) nach einem der Ansprüche 3 bis 6, **dadurch gekennzeichnet, dass** das Blindleistungsmodul (24) weiterhin eine Messeinheit (24e) und eine Auswerteeinheit (24f) umfasst und dass die Blindleistungsregeleinheit (24b) oder die Blindleistungssteuereinheit (24c) mit einem Datenspeicher (24g) und einer Eingabe-/Ausgabeeinheit für Sollwerte und Back-Up-Werte von Betriebsdaten (24h) sowie von der Messeinheit erfasste und von der Auswerteeinheit (24f) berechnete Istwerte verbindbar ist, wobei die Blindleistungsregeleinheit (24b) oder die Blindleistungssteuereinheit (24c) eine Recheneinheit (24i) mit hinterlegten Algorithmen zur Verarbeitung von Soll-, Ist- und Back-Up-Werten von Betriebsdaten umfasst.

8. Vorrichtung (A, 16) nach einem der Ansprüche 1 bis 7, **dadurch gekennzeichnet, dass** die Stromversorgungseinrichtung für Elektrofahrzeuge EVSE (25) mit mindestens einem uni- oder bidirektionalen Ladegerät zur Umrichtung zwischen Wechsel-/Drehstrom und Gleichstrom verbindbar ist, sodass mithilfe der Stromversorgungseinrichtung für Elektrofahrzeuge EVSE (25) über das Ladegerät Wirkleistung von dem mindestens einen Elektrofahrzeug aus einem Niederspannungsnetz (J, 4, 12, 26) aufgenommen oder von dem mindestens einen Elektrofahrzeug über das Ladegerät in ein Niederspannungsnetz (J, 4, 12, 26) abgegeben werden kann.

9. Vorrichtung (A, 16) nach Anspruch 8, **dadurch gekennzeichnet, dass** die Stromversorgungseinrichtung für Elektrofahrzeuge EVSE (25) über eine Kommunikationsverbindung (11) zu einem Kommunikationsnetz (7) und/oder eine Kommunikationsverbindung (20, 20a) zum Ladegerät für das Elektrofahrzeug für die Kommunikation zur Steuerung von Lade- und Entladevorgängen der Batterie eines Elektrofahrzeugs sowie zur Laststeuerung oder zur Einspeisesteuerung verfügt.

10. Vorrichtung (A, 16) nach einem der Ansprüche 1 bis 9, **dadurch gekennzeichnet, dass** sie mindestens einen Umrichter umfasst, wodurch ein Wirkleistungsaustausch zwischen mindestens einer elektrischen Energiequelle und mindestens einer elektrischen Energiesenke ermöglicht wird, wobei die elektrischen Energiequelle(n) ein Niederspannungsnetz oder eine Energieerzeugungsanlage oder ein elektrischer Energiespeicher oder eine Batterie eines Elektrofahrzeugs (21, 21 d) sein kann/können und die elektrischen Energiesenke(n) ein elektrischer Energiespeicher oder eine Batterie eines Elektrofahrzeugs (21, 21 d), wobei der Umrichter als Ladegerät für ein Elektrofahrzeug fungiert, oder ein Niederspannungsnetz sein kann/können, wobei das Niederspannungsnetz ein Niederspannungsnetz (4) eines Netzbetreibers, ein Niederspannungsnetz innerhalb eines Grundstückes oder eines Gebäudes oder einer Elektroinstallation (J, 12, 26) umfassen kann.

11. Verwendung einer Vorrichtung (A, 16) nach einem der Ansprüche 1 bis 10 in einem für die Elektromobilität vorgesehenen expliziten Strompfad, welcher von einem Niederspannungsnetz (4) über eine Elektroinstallation (J, 26) zu der Vorrichtung (A, 16), die universell im Innen- oder Außenbereich betrieben werden kann, führt.

12. Virtuelles Blindleistungskraftwerk, geeignet zur koordinierten Blindleistungserzeugung und -regelung für ein elektrisches Netz, aufweisend eine hierarchische Struktur mit mindestens einer übergeordneten Instanz (6), einem Cluster enthaltend mindestens eine Vorrichtung (A, 16) nach einem der Ansprüche 4 bis 10 und ein Kommunikationsnetz (7), **dadurch gekennzeichnet, dass** die mindestens eine übergeordnete Instanz (6) über elektrische, optische und/oder drahtlose Kommunikationsverbindungen (11) und das Kommunikationsnetz (7) mit dem Kommunikationsmodul des Blindleistungsmoduls (24) jeder Vorrichtung (A, 16) des Clusters verbindbar ist.

13. Virtuelles Blindleistungskraftwerk nach Anspruch 12, **dadurch gekennzeichnet, dass** die mindestens eine übergeordnete Instanz (6) über elektrische, optische und/oder drahtlose Kommunikationsverbindungen (11) und das Kommunikationsnetz (7) mit der Stromversorgungseinrichtung für Elektrofahrzeuge (25) verbindbar ist.

14. Virtuelles Blindleistungskraftwerk nach Anspruch 13, **dadurch gekennzeichnet, dass** eine zentral koordinierte und hochverfügbare Blindleistungserzeugung und -regelung eines Netzsegments, einer Netzebene oder netzebenenübergreifend realisierbar ist, indem die mindestens eine übergeordnete Instanz (6) über Kommunikationsverbindungen (11) mit Messeinrichtungen im Niederspannungsnetz (5) und Messeinrichtungen in vorgelagerten Netzebenen (2) und Elektrizitätszählern oder intelligenten Messsystemen (8) und Elektrizitätszählern oder intelligenten Messsystemen für Ladeenergie und Blindenergie (13) und mit mindestens einem SCADA Supervisory Control and Data Acquisition oder mindestens einem anderen Netzleitsystem verbindbar ist, sodass durch die mindestens eine übergeordnete Instanz (6) mithilfe der Kommunikationsverbindungen zu jeder Vorrichtung (A, 16) des Clusters eine zentral koordinierte und hochverfügbare Blindleistungserzeugung und -regelung eines Netzsegments, einer Netzebene oder netzebenenübergreifend realisierbar ist.

15. Verfahren zum Betrieb eines virtuellen Blindleistungskraftwerks gemäß einem der Ansprüche 12 bis 14, **gekennzeichnet durch** die folgenden Schritte:
a) Bestimmung von Messwerten der Messeinrichtungen (2) in den vorgelagerten elektrischen Netzebenen (1), der Messeinrichtungen (5) im Niederspannungsnetz (4), der Elektrizitätszähler oder intelligenten Messsysteme (8) sowie der Elektrizitätszähler oder intelligenten Messsysteme für Ladeenergie und Blindenergie (13),
b) Übermittlung der Messwerte aus Schritt a) das Kommunikationsnetz (7) mit den Kommunikationsverbindungen (11) erfolgt die Übermittlung von Messwerten an die übergeordnete Instanz (6),
c) auf der Grundlage der übermittelten Messwerte und unter Verwendung hinterlegter Algorithmen berechnet die übergeordnete Instanz (6) den aktuellen Netzzustand,
d) aus dem aktuellen Netzzustand, den Anforderungen von Betreibern vorgelagerter Netze und den Anforderungen an das virtuelle Blindleistungskraftwerk berechnet die übergeordnete Instanz (6) für ein nachfolgendes definiertes konstantes oder zeitveränderliches Intervall die Betriebsdaten für jede Vorrichtung (A, 16) im virtuellen Blindleistungskraftwerk, welche in Form einer Blindleistungs-Zeit-Funktion, *Q*(*t*), über das Kommunikationsnetz (7) mit den Kommunikationsverbindungen (11) an die jeweilige Vorrichtung (A, 16) übermittelt werden,
e) jede Vorrichtung (A, 16) speist die **durch** ihre Blindleistungs-Zeit-Funktion, *Q(t),* vorgegebene Blindleistung in das Niederspannungsnetz (4) ein,
f) die vorangehenden Schritte a) bis e) werden kontinuierlich wiederholt für das jeweils anschließende definierte konstante oder zeitveränderliche Intervall, sodass für jeden Zeitpunkt eine koordinierte Blindleistungserzeugung und -regelung entsprechend dem momentanen Blindleistungsbedarf im Gesamtkontext des aus dem Niederspannungsnetz (4) oder seinen vorgelagerten Netzebenen (1) aufgebauten elektrischen Netzes erfolgt.

16. Verfahren zum Betrieb einer Vorrichtung (A, 16) gemäß Anspruch 7 bis 10, **dadurch gekennzeichnet, dass** auf lokal in dem mit der Blindleistungsregeleinheit (24b) oder der Blindleistungssteuereinheit (24c) verbundenen Datenspeicher (24g) hinterlegte Back-Up-Werte mit entsprechenden Algorithmen zurückgegriffen wird, die sich auf gesammelte Erfahrungswerte des jeweiligen Blindleistungsmoduls (24) stützen oder durch eine übergeordnete Instanz (6) vorgegeben werden und in Verbindung mit lokalen Messwerten einen Notbetrieb der Blindleistungserzeugung und -regelung realisieren.
